# EUROPÄISCHE PATENTSCHRIFT

(11) **EP 3 222 674 B1**
(45) Veröffentlichungstag und Bekanntmachung des Hinweises auf die Patenterteilung: **03.10.2018**
(21) Anmeldenummer: 17158593.8
(22) Anmeldetag: 01.03.2017
(51) Int. Cl.: C09B 45/18, C09B 45/22, C09B 67/04, C09B 67/22

(54) **METALLAZOPIGMENTE**
METAL AZO PIGMENTS
PIGMENTS AZOÏQUES MÉTALLIQUES

(30) Priorität: 23.03.2016 EP 16161851
(43) Veröffentlichungstag der Anmeldung: 27.09.2017
(73) Patentinhaber: Lanxess Deutschland GmbH, 50569 Köln (DE)
(72) Erfinder: BORST, Hans-Ulrich, 50189 Elsdorf (DE); LINKE, Frank, 51069 Köln (DE); ENDERT, Sabine, 42327 Wuppertal (DE)

(56) Entgegenhaltungen:
- EP-A1- 1 591 489
- EP-A1- 2 682 434
- DE-A1- 19 945 245

## Beschreibung

Die vorliegende Erfindung betrifft neue gelbe Metallazopigmente auf Basis mindestens zweier Metallazoverbindungen die sich mindestens in der Art des Metalls voneinander unterscheiden, Verfahren zu deren Herstellung und deren Verwendung als Gelbpigment in Pigmentpräparationen

Die Herstellung von Metallkomplexen aus Azobarbitursäure mit Nickelsalzen und deren Verwendung als gelbe Pigmente ist lange bekannt und vielfach in der Literatur beschrieben (vgl. z.B. W. Herbst, K. Hunger: Industrial Organic Pigments, 3. Auflage 2004, S. 390/397). Es ist weiterhin bekannt, dass diese Produkte weiter umgesetzt werden können, z.B. mit Melamin oder Melaminderivaten, um die anwendungstechnischen Eigenschaften der Pigmente beispielsweise bei der Einfärbung von Kunststoffen, Lacken und Farbfiltern für LCDs zu verbessern.

Des Weiteren ist in der Literatur beschrieben, dass zur Anpassung coloristischer Eigenschaften außer Nickelsalzen auch ein oder mehrere Salze unterschiedlicher Metalle mitverwendet werden können. Die Anmeldung EP-A 1 591 489 beschreibt Metallkomplexe von Azoverbindungen, die als Metalle solche aus der Reihe der Alkalimetalle, Erdalkalimetalle, der Lanthanoiden sowie Aluminium, Scandium, Titan, Vanadium, Chrom, Mangan, Kobalt, Kupfer, Nickel und Zink und gegebenenfalls Eisen enthalten. Die erhaltenen Pigmente weisen einen unterschiedlichen Farbort auf im Vergleich zu den reinen Nickel-Azobarbitursäurekomplexen.

Durch eine gezielte Oberflächenbelegung der Metallazopigment kann ebenfalls eine Verbesserung anwendungsbezogener Eigenschaften erzielt werden, speziell die Erniedrigung der Dispergierhärte als einem Maß für die Disperiereigenschaften des Pigments. Mit diesem Verfahren zur Verbesserung der Dispergierbarkeit ist jedoch eine Reduzierung der Farbstärke des Pigments verbunden, die in direkter Abhängigkeit von der Konzentration an Belegungsmittel steht.

Eine weitere Möglichkeit der Anpassung anwendungsbezogener Eigenschaften ist es die aus Nickel-Azobarbitursäurekomplexe mit z.B. Melamin hergestellten Pigmente zu tempern. Mit diesem Verfahrensschritt ist eine gezielte Änderung der Teilchengröße der Pigmente und deren spezifischer Oberfläche verbunden. Dieses Verfahren ist z.B. in EP-A 0 994 162 beschrieben.

Die aus dem Stand der Technik bekannten Metallazopigmente sind hinsichtlich ihrer anwendungstechnischen Eigenschaften allerdings noch verbesserungsbedürftig.

Es wurde gefunden, dass Metallazopigmente auf Basis von Azobarbitursäure, Nickelsalzen und Melamin und/oder Melaminderivaten und mindestens einem weiteren Lanthanoidensalz , überraschender Weise verbesserte Farbstärken aufweisen. Die Verbesserung dieser Eigenschaften ermöglichen den verbesserten Einsatz dieser Produkte u.a. zur Kunststoff- und Lackeinfärbung, zur Verwendung im InkJet und als Komponente von Farbfiltern für LCDs.

Die Erfindung betrifft daher Metallazopigmente, dadurch gekennzeichnet, dass sie enthalten die Komponenten
a) mindestens zwei Metallazoverbindungen die sich mindestens in der Art des Metalls voneinander unterscheiden, und die jeweils
   - Struktureinheiten der Formel (I), oder deren tautomeren Formen, 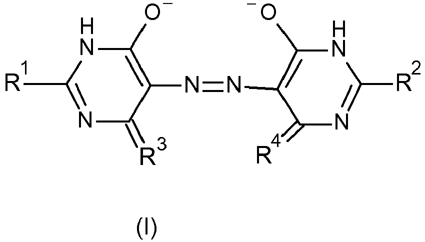 worin
      R¹ und R² unabhängig voneinander für OH, NH₂ oder NHR⁵ stehen,
      R³ und R⁴ unabhängig voneinander für =O oder =NR⁵ stehen,
      R⁵ für Wasserstoff oder Alkyl, vorzugsweise C₁-C₄-Alkyl, steht,
         und
   - Ni²⁺-Metallionen beziehungsweise ein oder mehrere Metallionen Me¹ und gegebenenfalls ein oder mehrere Metallionen Me² enthalten,
      wobei
      Me¹ für ein Metallion ausgewählt aus der Reihe La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺, Yb²⁺ und Yb³⁺ steht,
      und
      Me² für ein Metallion ausgewählt aus der Reihe Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Fe²⁺, Fe³⁺, Co²⁺, Co³⁺, Cu²⁺, Zn²⁺, Cd²⁺, Al³⁺ und Pb²⁺ steht, mit der Maßgabe, dass die Menge an Ni²⁺-Metallionen und Metallionen aus der Reihe Me¹ zusammen 95 bis 100 Mol-% beträgt und die Menge an Metallionen aus der Reihe Me² 0 bis 5 Mol-% beträgt, jeweils bezogen auf ein Mol aller Metallionen im Metallazopigment,
      und
      wobei das Molverhältnis von Ni²⁺- Metallionen zu Me¹ Metallionen im Metallazopigment 2 : 1 bis 4 : 1 und bevorzugt 2,3 : 1 bis 3 : 1 beträgt,
      und
b) mindestens eine Verbindung der Formel (II) 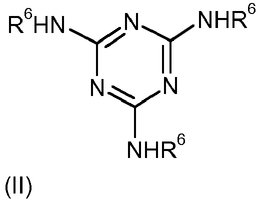 worin
   R⁶ für Wasserstoff oder Alkyl, vorzugsweise C₁-C₄-Alkyl das gegebenenfalls ein- oder mehrfach durch OH substituiert ist,
steht. Vorzugsweise stehen in Formel (I) R¹ und R² unabhängig voneinander für OH, NH₂ oder NHR⁵, wobei R⁵ für Wasserstoff oder C₁-C₄-Alkyl, steht.
Vorzugsweise stehen in Formel (I) R³ und R⁴ unabhängig voneinander für =O oder =NR⁵, wobei R⁵ für Wasserstoff oder C₁-C₄-Alkyl steht.
Besonders bevorzugt stehen in Formel (I) R¹ und R² für OH und R³ und R⁴ für =O.

Vorzugsweise steht in Formel (II) R⁶ für Wasserstoff oder C₁-C₄-Alkyl das gegebenenfalls ein- oder mehrfach durch OH substituiert ist. Besonders bevorzugt steht in Formel (II) R⁶ für Wasserstoff.
Bezogen auf ein Mol aller im Metallazopigment vorhandenen Metallionen beträgt die Menge an Ni²⁺- und Me¹-Metallionen zusammen allgemein 95 bis 100 Mol-% und die Menge an Metallionen Me² 0 bis 5 Mol-%, vorzugsweise beträgt die Menge an Ni²⁺- und Me¹-Metallioonen zusammen 98 bis 100 Mol-% und die Menge an Metallionen Me² 0 bis 2 Mol-%, und besonders bevorzugt beträgt die Menge an Ni²⁺-und Me¹-Metallionen zusammen 99,9 bis 100 Mol-% und die Menge an Metallionen Me² 0 bis 0,1 Mol-%.

Allgemein beträgt das Molverhältnis von Ni²⁺- zu Me¹- Metallionen im Metallazopigment 2 : 1 bis 4 : 1 und bevorzugt 2,3 : 1 bis 3 : 1. Substituenten in der Bedeutung von Alkyl bezeichnen beispielsweise geradkettiges oder verzweigtes C₁-C₆-Alkyl, vorzugsweise geradkettiges oder verzweigtes C₁-C₄-Alkyl, das gegebenenfalls ein- oder mehrfach, gleich oder verschieden substituiert sein kann, beispielsweise durch Halogen, wie Chlor, Brom oder Fluor, sowie durch -OH, -CN, -NH₂ oder C₁-C₆-Alkoxy.
Die Metallionen Me¹ und Me² liegen vorzugsweise in ihren stabilsten Oxidationsstufen vor. Me¹ steht allgemein für ein Metallion ausgewählt aus der Reihe La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺, Yb²⁺ und Yb³⁺ . Bevorzugt steht Me¹ für ein Metallion ausgewählt aus der Reihe La³⁺, Ce³⁺, Pr³⁺, Nd³⁺, Sm³⁺, Eu³⁺, Gd³⁺, Tb³⁺, Dy³⁺, Ho³⁺, Er³⁺, Tm³⁺ und Yb³⁺, und besonders bevorzugt aus der Reihe La³⁺, Ce³⁺, Pr³⁺, Nd³⁺, Sm³⁺, Tb³⁺ und Ho³⁺.
Me² steht allgemein für ein Metallion ausgewählt aus der Reihe Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Fe²⁺, Fe³⁺, Co²⁺, Co³⁺, Cu²⁺, Zn²⁺, Cd²⁺, Al³⁺ und Pb²⁺.
Bevorzugt steht Me² für ein Metallion ausgewählt aus der Reihe Mg²⁺, Ca²⁺, Sr²⁺, Y³⁺, Mn²⁺, Fe²⁺, Fe³⁺, Co²⁺, Co³⁺, Cu²⁺, Zn²⁺, Al³⁺, und besonders bevorzugt aus der Reihe Sr²⁺, Fe²⁺, Fe³⁺, Co²⁺, Co³⁺, Cu²⁺, Zn²⁺ und Al³⁺.
Im Fall, dass Metallazoverbindungen der Komponente a) 2-wertige Metallionen Me aus der Reihe Me¹ und Me² enthalten, können die Struktureinheiten der Formel (I) und die Metallionen Me als Verbindungen der Formel (la) 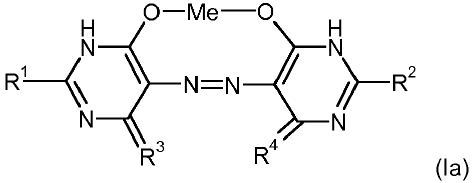 aufgefasst werden. Es ist aber auch möglich, dass das Metallion in einer tautomeren Schreibweise der Formel (la) über die Stickstoffatome gebunden ist.

Die gleiche formelmäßige Darstellung kann auf die Struktureinheiten der Formel (I) mit den Ni²⁺-Metallionen angewendet werden. Diese Darstellung dient nur zur Veranschaulichung und erhebt keinen Anspruch auf wissenschaftliche Korrektheit.

Im Fall, dass es sich um 3-wertige Metallionen Me¹ und Me² handelt, erfolgt der Ladungsausgleich durch eine äquivalente Menge an anionischen Struktureinheiten der Formel (I).

Vorzugsweise erfolgt der Ladungsausgleich der zweifach negativ geladenen Struktureinheiten der Formel (I) zu 80 bis 100%, besonders bevorzugt zu 95 bis 100% und ganz besonders bevorzugt zu 99,9 bis 100% durch die Summe aller im Metallazopigment vorhandenen Ni²⁺- und Me¹-Metallionen und gegebenenfalls weiteren Metallionen Me².

Vorzugsweise bilden die genannten Metallazoverbindungen der Komponenten a) mit den Komponenten b), d.h. den Verbindungen der Formel (II), Addukte.

Als Addukte sind dabei generell zusammengesetzte Moleküle zu verstehen. Dabei kann die Bindung zwischen den Molekülen beispielsweise durch intermolekulare Wechselwirkungen oder Lewis-Säure-Base Wechselwirkungen oder durch koordinative Bindungen erfolgen.

Der Begriff Addukt soll im Sinne der vorliegenden Erfindung generell alle Arten von Ein- und Anlagerungsverbindungen umfassen.

Unter den Begriffen "Einlagerungsverbindung" oder "Anlagerungsverbindung" im Sinne der vorliegenden Erfindung sollen beispielsweise Verbindungen verstanden werden, die aufgrund von intermolekularen Wechselwirkungen wie Van-der Waals-Wechselwirkungen oder auch Lewis-Säure-Base Wechselwirkungen gebildet werden. Dabei hängt es sowohl von den chemischen Eigenschaften der einzulagernden Komponente, aber auch von der chemischen Natur des Wirtsgitters ab, wie die Einlagerung abläuft. Solche Verbindungen werden häufig auch als Interkalationsverbindungen bezeichnet. Im chemischen Sinn versteht man darunter die Einlagerung von Molekülen, Ionen (selten auch Atomen) in chemische Verbindungen.

Weiterhin sollen darunter auch Einschlussverbindungen, sogenannte Clathrate, verstanden werden. Diese stellen Verbindungen zweier Stoffe dar, von denen ein Gastmolekül in ein Gitter oder Käfig aus einem Wirtsmolekül eingelagert ist.

Unter den Begriffen "Einlagerungsverbindung" oder "Anlagerungsverbindung" im Sinne der vorliegenden Erfindung sollen auch Einlagerungsmischkristalle (auch interstitielle Verbindung) verstanden werden. Es handelt es sich hierbei um chemische, nichtstöchiometrische, kristalline Verbindungen aus mindestens zwei Elementen.

Weiterhin sollen unter den Begriffen "Einlagerungsverbindung" oder "Anlagerungsverbindung" im Sinne der vorliegenden Erfindung auch Verbindungen verstanden werden, die aufgrund von koordinativen Bindungen oder Komplexbindungen gebildet werden. Als solche Verbindungen werden z.B. Substitutionsmischkristall oder Austauschmischkristall bezeichnet, bei dem mindestens zwei Stoffe einen gemeinsamen Kristall bilden und die Atome der zweiten Komponente auf regulären Gitterplätzen der ersten Komponente sitzen.

Bevorzugt sind Metallazopigmente enthaltend die Addukte aus
a) mindestens zwei Metallazoverbindungen die sich mindestens in der Art des Metalls unterscheiden und die jeweils Struktureinheiten der oben angegebenen Formel (I),
   worin R¹ und R² für OH stehen,
   und
   R³ und R⁴ für =O stehen,
   und
   Ni²⁺- Metallionen beziehungsweise ein oder mehrere Metallionen Me¹ und gegebenenfalls ein oder mehrere Metallion Me² enthalten,
   wobei
   Me¹ für ein Metallion ausgewählt aus der Reihe La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺, Yb²⁺ und Yb³⁺ steht, bevorzugt aus der Reihe La³⁺, Ce³⁺, Pr³⁺, Nd³⁺, Sm³⁺, Eu³⁺, Gd³⁺, Tb³⁺, Dy³⁺, Ho³⁺, Er³⁺, Tm³⁺ und Yb³⁺, und besonders bevorzugt aus der Reihe La³⁺, Ce³⁺, Pr³⁺, Nd³⁺, Sm³⁺, Tb³⁺ und Ho³⁺ steht,
   und
   Me² für ein Metallion ausgewählt aus der Reihe Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Fe²⁺, Fe³⁺, Co²⁺, Co³⁺, Cu²⁺, Zn²⁺, Cd²⁺, Al³⁺ und Pb²⁺ steht, bevorzugt aus der Reihe Mg²⁺, Ca²⁺, Sr²⁺, Y³⁺, Mn²⁺, Fe²⁺, Fe³⁺, Co²⁺, Co³⁺, Cu²⁺, Zn²⁺, Al³⁺, und besonders bevorzugt aus der Reihe Sr²⁺, Fe²⁺, Fe³⁺, Co²⁺, Co³⁺, Cu²⁺, Zn²⁺ und Al³⁺ steht,
   mit der Maßgabe, dass die Menge an Ni²⁺-Metallionen und Metallionen aus der Reihe Me¹ zusammen 95 bis 100 Mol-% beträgt und die Menge an Metallionen aus der Reihe Me² 0 bis 5 Mol-% beträgt, jeweils bezogen auf ein Mol aller Metallionen im Metallazopigment,
   und
   wobei das Molverhältnis von Ni²⁺- Metallionen zu Me¹ Metallionen im Metallazopigment 2 : 1 bis 4 : 1 und bevorzugt 2,3 : 1 bis 3 : 1 beträgt,
   und
b) mindestens einer Verbindung der oben angegebenen Formel (II)
   worin
   R⁶ für Wasserstoff steht.
Besonders bevorzugt sind Metallazopigmente enthaltend die Addukte aus
a) mindestens zwei Metallazoverbindungen die sich mindestens in der Art des Metalls unterscheiden und die jeweils Struktureinheiten der oben angegebenen Formel (I),
   worin
   R¹, R², R³, R⁴ und R⁵ die oben angegebenen allgemeinen und bevorzugten Bedeutung haben, und
   Ni²⁺- Ionen beziehungsweise ein oder mehrere Metallionen Me¹ enthalten,
   wobei
   Me¹ für ein Metallion ausgewählt aus der Reihe La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺, Yb²⁺ und Yb³⁺ steht, bevorzugt für ein Metallion ausgewählt aus der Reihe La³⁺, Ce³⁺, Pr³⁺, Nd³⁺, Sm³⁺, Eu³⁺, Gd³⁺, Tb³⁺, Dy³⁺, Ho³⁺, Er³⁺, Tm³⁺ und Yb³⁺, und besonders bevorzugt aus der Reihe La³⁺, Ce³⁺, Pr³⁺, Nd³⁺, Sm³⁺, Tb³⁺ und Ho³⁺ steht,
   mit der Maßgabe, dass die Menge an Ni²⁺-Ionen und Metallionen aus der Reihe Me¹ 100 Mol-% beträgt, bezogen auf ein Mol aller Metallionen im Metallazopigment,
   und
   wobei das Molverhältnis von Ni²⁺- Metallionen zu Me¹ Metallionen im Metallazopigment 2 : 1 bis 4 : 1 und bevorzugt 2,3 : 1 bis 3 : 1 beträgt,
   und
b) mindestens einer Verbindung der oben angegebenen Formel (II) worin R⁶ die oben angegebenen allgemeinen und bevorzugten Bedeutungen hat.
Verbindungen, die geeignet sind mit den Metallazoverbindungen der Komponente a) ein Addukt im Sinne der obigen Definition zu bilden können sowohl organische als auch anorganische Verbindungen sein. Im Folgenden werden diese Verbindungen als Adduktbildner bezeichnet.
Prinzipiell geeignete Adduktbildner entstammen den verschiedenartigsten Verbindungsklassen. Aus rein praktischen Gründen sind solche Verbindungen bevorzugt, die unter Normalbedingungen (25°C, 1 bar) flüssig oder fest sind.
Von den flüssigen Substanzen sind generell solche bevorzugt, die einen Siedepunkt von 100°C oder darüber, bevorzugt von größer gleich 150°C bei 1 bar, aufweisen. Geeignete Adduktbildner sind generell acyclische und cyclische organische Verbindungen, z.B. aliphatische und aromatische Kohlenwasserstoffe, die substituiert sein können, z.B. durch OH, COOH, NH₂, substituiertes NH₂, CONH₂, substituiertes CONH₂, SO₂NH₂, substituiertes SO₂NH₂, SO₃H, Halogen, NO₂, CN, -SO₂-Alkyl, -SO₂-Aryl, -O-Alkyl, -O-Aryl, -O-Acyl.
Carbonsäure- und Sulfonsäureamide sind eine bevorzugte Gruppe von Adduktbildnern, insbesondere geeignet sind auch Harnstoff und substituierte Harnstoffe wie Phenylharnstoff, Dodecylharnstoff und andere sowie deren Polykondensate mit Aldehyden, insbesondere Formaldehyd; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Ebenfalls als Adduktbildner prinzipiell geeignet sind Polymere, vorzugsweise wasserlösliche Polymere, z.B. Ethylen-propylenoxid-Blockpolymere, vorzugsweise mit einem Mₙ größer gleich 1.000, insbesondere von 1.000 bis 10.000 g/mol, Polyvinylalkohol, Poly-(meth)-acrylsäuren, modifizierte Cellulose, wie Carboxymethylcellulosen, Hydroxyethyl- und -propylcellulosen, Methyl- und Ethylhydroxyethylcellulosen.

Erfindungsgemäß werden als Adduktbildner solche der Formel (II) eingesetzt. Insbesondere bevorzugt ist dabei Melamin.

Im Allgemeinen enthalten die erfindungsgemäßen Metallazopigmente pro Mol an Struktureinheiten der Formel (I) 0,05 bis 4 Mol, bevorzugt 0,5 bis 2,5 Mol und ganz besonders bevorzugt 1,0 bis 2,0 Mol an Verbindungen der Formel (II).

Die erfindungsgemäßen Metallazopigmente besitzen vorzugsweise eine spezifische Oberfläche (m²/g) von 20 bis 200 m²/g, insbesondere 60 bis 160 m²/g, ganz besonders bevorzugt 90 bis 150 m²/g. Die Oberfläche wird nach DIN 66131 ermittelt: Bestimmung der spezifischen Oberfläche von Feststoffen durch Gasadsorption nach Brunauer, Emmett und Teller (B.E.T).

Bei den erfindungsgemäßen Metallazopigmenten kann es sich um physikalische Mischungen oder um chemische Mischverbindungen handeln. Vorzugsweise handelt es sich bei den physikalischen Mischungen um Mischungen von Addukten aus den genannten Metallazoverbindungen der Komponente a) und den Verbindungen der Formel (II) der Komponente b) die sich zumindest hinsichtlich der Art der Metalle unterscheiden. Beispielsweise und bevorzugt handelt es sich um die physikalische Mischung der Addukte aus a1) der reinen Ni-Azoverbindung mit b1) Melamin und der Addukte aus a2) einer oder mehrer Me¹ -Azoverbindungen mit b2) Melamin und gegebenenfalls der Addukte aus a3) einer oder mehrer Me² -Azoverbindung mit b3) Melamin. Bei den chemischen Mischverbindungen handelt es sich beispielsweise und bevorzugt um Addukte von Metallazoverbindungen der Komponente a) mit Verbindungen der Formel (II) der Komponente b), vorzugsweise Melamin, bei denen die Ni²⁺- und Me¹-Metallionen, und gegebenenfalls weitere Metallion Me², in ein gemeinsames Kristallgitter eingebaut sind.

Die erfindungsgemäßen Metallazopigmente können hergestellt werden durch Umsetzung von Alkalisalzen der Formel (III), oder deren Tautomeren, bevorzugt der Natrium- oder Kaliumsalze, in Gegenwart von mindestens einer Verbindung der Formel (II) mit Nickelsalzen und einem oder mehreren Me¹-Salzen und gegebenenfalls einem oder mehreren Me²- Salzen.

Unter Me¹-Salzen sind im Sinne der vorliegenden Erfindung Salze der zwei- oder dreiwertigen Metalle Lanthan, Cer, Praseodym, Neodym, Samarium, Europium, Gadolinium, Terbium, Dysprosium, Holmium, Ytterbium, Erbium, Thulium, besonders bevorzugt der zwei- oder dreiwertigen Metalle Lanthan, Cer, Praseodym, Neodym, Samarium, Terbium und Holmium zu verstehen.

Unter Me²- Salzen sind im Sinne der vorliegenden Erfindung Salze der zwei- oder dreiwertigen Metalle Zink, Kupfer, Aluminium, Eisen, Kobalt, Magnesium, Kalzium, Strontium, Mangan, Yttrium, Scandium, Titan, Niob, Molybdän, Vanadium, Zirkonium, Cadmium, Chrom, Blei und Barium, bevorzugt Zink, Kupfer, Aluminium, Eisen, Kobalt, Magnesium, Kalzium, Strontium, Mangan und Yttrium und besonders bevorzugt Zink, Kupfer, Aluminium, Eisen, Kobalt und Strontium zu verstehen.

Die erfindungsgemäßen Metallazopigmente können auch hergestellt werden durch Mischen der Addukte aus a1) Metallazoverbindungen die Struktureinheiten der Formel (I) und Ni²⁺-Metallionen enthalten und b1) Verbindungen der Formel (II) mit Addukten aus a2) Metallazoverbindungen die Struktureinheiten der Formel (I) und ein oder mehrere Metallionen Me¹ enthalten und b2) Verbindungen der Formel (II), gegebenenfalls mit Addukten a3) aus Metallazoverbindungen die Sturktureinheiten der Formel (I) und ein oder mehrere Metallionen Me² enthalten und b3) Verbindungen der Formel (II).

Weiterer Gegenstand der vorliegenden Erfindung ist ein Verfahren zur Herstellung der erfindungsgemäßen Metallazopigmente das dadurch gekennzeichnet ist, dass man mindestens eine Verbindung der Formel (III), oder deren Tautomere, 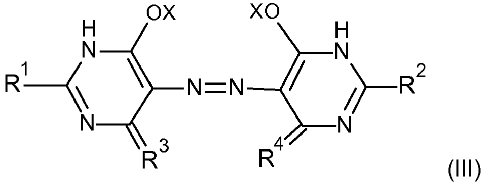 worin
X für ein Alkalimetallion, vorzugsweise für ein Natrium- oder Kaliumion steht,
R¹ und R² unabhängig voneinander für OH, NH₂ oder NHR⁵ stehen,
R³ und R⁴ unabhängig voneinander für =O oder =NR⁵ stehen,
und
R⁵ für Wasserstoff oder Alkyl, bevorzugt C₁-C₄-Alkyl, steht,
in Gegenwart von mindestens einer Verbindung der Formel (II) gleichzeitig oder nacheinander mit mindestens einem Nickelsalz und mindestens einem weiteren Me¹-Metallsalz aus der Reihe der zwei- oder dreiwertigen La³⁺-, Ce³⁺-, Pr³⁺-, Nd²⁺-, Nd³⁺-, Sm²⁺-, Sm³⁺-, Eu²⁺-, Eu³⁺-, Gd³⁺-, Tb³⁺-, Dy³⁺-, Ho³⁺-, Er³⁺-, Tm³⁺-, Yb²⁺ - und Yb³⁺ - Salze, bevorzugt aus der Reihe der La³⁺-, Ce³⁺-, Pr³⁺-, Nd³⁺-, Sm³⁺-, Eu³⁺-, Gd³⁺-, Tb³⁺-, Dy³⁺-, Ho³⁺-, Er³⁺-, Tm³⁺- und Yb³⁺-Salze und besonders bevorzugt aus der Reihe der La³⁺-, Ce³⁺-, Pr³⁺-, Nd³⁺-, Sm³⁺-, Tb³⁺ - und Ho³⁺-Salze und gegebenenfalls mit einem oder mehreren Me²- Metallsalzen aus der Reihe der Mg²⁺-, Ca²⁺-, Sr²⁺-, Ba²⁺-, Sc³⁺-, Y³⁺-, Ti²⁺-, Ti³⁺-, Zr²⁺-, Zr³⁺, V²⁺-, V³⁺-, Nb³⁺-, Cr³⁺-, Mo²⁺-, Mo³⁺-, Mn²⁺-, Fe²⁺-, Fe³⁺-, Co²⁺-, Co³⁺-, Cu²⁺-, Zn²⁺-, Cd²⁺-, Al³⁺ - und Pb²⁺-Salze, bevorzugt aus der Reihe der Mg²⁺-, Ca²⁺-, Sr²⁺-, Y³⁺-, Mn²⁺-, Fe²⁺-, Fe³⁺-, Co²⁺-, Co³⁺-, Cu²⁺-, Zn²⁺-, Al³⁺- Salze und besonders bevorzugt aus der Reihe der Sr²⁺-, Fe²⁺-, Fe³⁺-, Co²⁺-, Co³⁺-, Cu²⁺-, Zn²⁺ - und Al³⁺-Salze umsetzt,
wobei pro Mol an Verbindung der Formel (III) 0,66 bis 0,80 Mol mindestens eines Nickelsalz, 0,20 bis 0,33 Mol mindestens eines Me¹- Salzes und und höchstens 0,05 Mol mindestens eines Me²- Salzes eingesetzt werden, und wobei die Summe der Molmengen der insgesamt eingestzten Metallsalze ein Mol beträgt.

Bevorzugt werden pro Mol an Verbindung der Formel (III) 0,70 bis 0,75 Mol mindestens eines Nickelsalzes und 0,25 bis 0,30 Mol mindestens eines Me¹- Salzes eingesetzt.

Im Allgemeinen werden zur Durchführung des erfindungsgemäßen Verfahrens pro Mol an Verbindung der Formel (III) 0,05 bis 4 Mol, bevorzugt 0,5 bis 2,5 Mol und ganz besonders bevorzugt 1,0 bis 2,0 Mol an Verbindung der Formel (II) eingesetzt.

Alternativ kann zur Herstellung an Stelle der Dialkaliverbindung der Formel (III) auch eine Monoalkaliverbindung der Formel (lila), oder deren Tautomere, 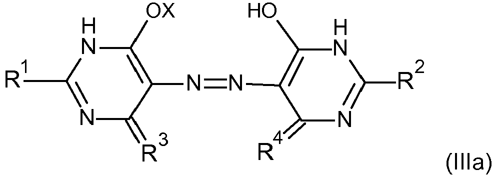 worin X, R¹, R², R³ und R⁴ die für Formel (III) angegebene Bedeutung haben,
oder eine Mischung aus Verbindungen der Formel (III) und (IIIa) eingesetzt werden. Dabei beziehen sich die angegebenen Molmengen an Nickel- und Me¹-Salzen und gegebenenfalls einzusetzenden Me²- Salzen sowie an Verbindungen der Formel (II) in diesen Fällen auf die Summe der Molmenge der eingesetzten Verbindungen (III) und (IIIa).

Insbesondere bevorzugt ist die Herstellung von binären Nickel- / Me¹- Azobarbitursäure-Melamin Addukten.

Das erfindungsgemäße Verfahren wird im Allgemeinen bei einer Temperatur von 60 bis 95 °C in wässriger Lösung bei einem pH-Wert unterhalb von 7 durchgeführt. Die erfindungsgemäß einzusetzenden Zink- und Kupfersalze und die gegebenenfalls einzusetzenden weiteren Metallsalze können einzeln oder als Gemisch untereinander, bevorzugt in Form einer wässrigen Lösung eingesetzt werden. Die Verbindungen der Formel (II) können ebenfalls einzeln oder als Mischung untereinander zugegeben werden, bevorzugt in Form der Feststoffe.

Im Allgemeinen wird das erfindungsgemäße Verfahren so durchgeführt, dass die Azoverbindung der Formel (III), vorzugsweise als Na- oder K-Salz, vorgelegt wird, dass eine oder mehrere Verbindungen der Formel (II), vorzugsweise Melamin, zugegeben werden und danach, gleichzeitig oder nacheinander, mit mindestens einem Nickelsalz und mindestens einem Me¹- Salz und gegebenenfalls mindestens einem Me²- Salz, vorzugsweise in Form der wässrigen Lösungen dieser Salze, umgesetzt wird, vorzugsweise bei pH-Werten kleiner 7.

Zur Einstellung des pH-Wertes eignen sich Natronlauge, Kalilauge, Natriumcarbonat, Natriumhydrogencarbonat, Kaliumcarbonat und Kaliumhydrogencarbonat.

Als Nickelsalze kommen vorzugsweise deren wasserlösliche Salze in Frage, insbesondere Chloride, Bromide, Acetate, Formiate, Nitrate, Sulfate usw. Bevorzugt eingesetzte Nickelsalze besitzen eine Wasserlöslichkeit von mehr als 20 g/l, insbesondere mehr als 50 g/l bei 20°C.

Als Me¹- Salze kommen vorzugsweise die wasserlöslichen Salze der zwei- oder dreiwertigen Metalle Lanthan, Cer, Praseodym, Neodym, Samarium, Europium, Gadolinium, Terbium, Dysprosium, Holmium, Ytterbium, Erbium, Thulium, besonders bevorzugt der zwei- oder dreiwertigen Metalle Lanthan, Cer, Praseodym, Neodym, Samarium, Terbium und Holmium in Frage, vorzugsweise deren Chloride, Bromide, Acetate, Nitrate und Sulfate, besonders bevorzugt deren Chloride.

Als Me²- Salzen kommen ebenfalls vorzugsweise die wasserlöslichen Salze der zwei- oder dreiwertigen Metalle Zink, Kupfer, Aluminium, Eisen, Kobalt, Magnesium, Kalzium, Strontium, Mangan, Yttrium, Scandium, Titan, Niob, Molybdän, Vanadium, Zirkonium, Cadmium, Chrom, Blei und Barium, bevorzugt Zink, Kupfer, Aluminium, Eisen, Kobalt, Magnesium, Kalzium, Strontium, Mangan und Yttrium und besonders bevorzugt Zink, Kupfer, Aluminium, Eisen, Kobalt und Strontium in Frage, vorzugsweise deren Chloride, Bromide, Acetate, Nitrate und Sulfate, besonders bevorzugt deren Chloride.

Die auf diese Weise erhaltenen erfindungsgemäßen Metallazopigmente können dann durch Filtration ihrer wässrigen Suspension als wässriger Nutschkuchen isoliert werden. Dieser Nutschkuchen kann, gegebenenfalls nach Waschen mit heißem Wasser, mittels üblicher Trocknungsverfahren getrocknet werden.

Als Trocknungsverfahren kommen beispielsweise die Schaufeltrocknung oder die Sprühtrocknung entsprechender wässriger Slurries in Frage.
Anschließend kann das Pigment nachgemahlen werden.

Sofern die erfindungsgemäßen Metallazopigmente für die gewünschte Anwendung zu kornhart bzw. zu dispergierhart sind, können sie beispielsweise gemäß der in DE-A 19 847 586 beschriebenen Methode in kornweiche Pigmente umgewandelt werden.

Weiterer Gegenstand der vorliegenden Erfindung ist ein Verfahren zur Herstellung der erfindungsgemäßen Metallazopigmenten das dadurch gekennzeichnet ist, dass man
(i) mindestens ein Addukt aus
   a1) einer Metallazoverbindung die Stuktureinheiten der oben angegebenen Formel (I),
      worin
   R¹, R², R³, R⁴ und R⁵ die oben angegebenen allgemeinen und bevorzugten Bedeutung haben,
      und
   Ni²⁺ -Ionen enthält,
      und
   b1) mindestens einer Verbindung der oben angegebenen Formel (II), worin R⁶ die oben angegebenen allgemeinen und bevorzugten Bedeutungen hat,
      und die Menge an Ni²⁺-Metallionen 100 Mol-% beträgt, bezogen auf ein Mol aller Metallionen im Addukt a1)/b1),
      mit
(ii) mindestens einem Addukt aus
   a2) einer Metallazoverbindung die Stuktureinheiten der oben angegebenen Formel (I),
      worin
      R¹, R², R³, R⁴ und R⁵ die oben angegebenen allgemeinen und bevorzugten Bedeutung haben,
      und
      Metallionen Me¹ enthält,
      wobei
      Me¹ für ein Metallion ausgewählt aus der Reihe
      La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺, Yb²⁺ und Yb³⁺ steht, bevorzugt aus der Reihe La³⁺, Ce³⁺, Pr³⁺, Nd³⁺, Sm³⁺, Eu³⁺, Gd³⁺, Tb³⁺, Dy³⁺, Ho³⁺, Er³⁺, Tm³⁺ und Yb³⁺, und besonders bevorzugt aus der Reihe La³⁺, Ce³⁺, Pr³⁺, Nd³⁺, Sm³⁺, Tb³⁺ und Ho³⁺ steht,
      und
   b2) mindestens einer Verbindung der oben angegebenen Formel (II), worin R⁶ die oben angegebenen allgemeinen und bevorzugten Bedeutungen hat,
      und die Menge an Me¹-Metallionen 100 Mol-% beträgt, bezogen auf ein Mol aller Metallionen im Addukt a2)/b2),
      und gegebenenfalls mit
(iii) mindestens einem Addukt aus
   a3) einer Metallazoverbindung die Sturktureinheiten der oben angegebenen Formel (I),
      worin
      R¹, R², R³, R⁴ und R⁵ die oben angegebenen allgemeinen und bevorzugten Bedeutung haben,
      und
      Metallionen Me² enthält,
      wobei
      Me² für ein Metallion ausgewählt aus der Reihe Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Fe²⁺, Fe³⁺, Co²⁺, Co³⁺, Cu²⁺, Zn²⁺, Cd²⁺, Al³⁺ und Pb²⁺ steht, bevorzugt aus der Reihe Mg²⁺, Ca²⁺, Sr²⁺, Y³⁺, Mn²⁺, Fe²⁺, Fe³⁺, Co²⁺, Co³⁺, Cu²⁺, Zn²⁺, Al³⁺, und besonders bevorzugt aus der Reihe Sr²⁺, Fe²⁺, Fe³⁺, Co²⁺, Co³⁺, Cu²⁺, Zn²⁺ und Al³⁺ steht,
      und
   b3) mindestens einer Verbindung der oben angegebenen Formel (II), worin R⁶ die oben angegebenen allgemeinen und bevorzugten Bedeutungen hat,
      und die Menge an Me²-Metallionen 100 Mol-% beträgt, bezogen auf ein Mol aller Metallionen im Addukt a3)/b3),
miteinander vermischt.

Bei der Herstellung binärer Adduktmischungen werden pro Mol an Addukt a1)/b1) 0,25 bis 0,5 Mol an Addukt a2)/b2), vorzugsweise pro Mol an Addukt a1)/b1) 0,33 bis 0,43 Mol an Addukt a2)/b2) eingesetzt. Die erfindungsgemäßen Metallazopigmente zeichnen sich durch besonders gute Dispergierbarkeit und eine hohe Farbstärke aus. Chroma und Transparenz sind hervorragend einstellbar.
Die erfindungsgemäßen Metallazopigmente eignen sich hervorragend für alle Pigmentanwendungszwecke, insbesondere auch in Form ihrer Pigmentpräparationen.
Ein weiterer Gegenstand der vorliegenden Erfindung sind Pigmentpräparationen enthaltend wenigstens ein erfindungsgemäßes Metallazopigment und wenigstens einen Hilfs- und/oder Zusatzstoff.
Als Hilfs- oder Zusatzstoffe kommen im allgemeinen alle für Pigmentpräparationen üblichen Zusätze in Frage, beispielsweise solche aus der Reihe der oberflächenaktiven Mittel wie Dispergiermittel, Tenside, Netzmittel, Emulgatoren, sowie solche aus der Reihe der Oberflächenbelegungsmittel, der Basen und Lösungsmittel. Prinzipiell richtet sich der Hilfs- oder Zusatzstoff nach der Art des Zielsystems. Ist das Zielsystem z.B. ein Lack oder eine Druckfarbe dann wird der Hilfs- oder Zusatzstoff so ausgewählt, dass eine möglichst hohe Kompatibilität mit dem Zielsystem erreicht wird.
Vorzugsweise enthalten die erfindungsgemäßen Pigmentpräparationen mindestens ein oberflächenaktives Mittel.
Unter oberflächenaktiven Mitteln im Rahmen der vorliegenden Erfindung werden insbesondere Dispergiermittel verstanden, die die Pigmentteilchen in ihrer feinen partikulären Form in wässrigen Medien stabilisieren. Unter fein partikulär wird vorzugsweise eine Feinverteilung von 0,001 bis 5 µm verstanden, insbesondere von 0,005 bis 1 µm, besonders bevorzugt von 0,005 bis 0,5 µm. Die erfindungsgemäßen Pigmentpräparation liegt vorzugsweise fein partikulär vor.
Geeignete oberflächenaktive Mittel sind beispielsweise anionischer, kationischer, amphoterer oder nichtionogener Natur.
Geeignete anionische oberflächenaktive Mittel (c) sind insbesondere Kondensationsprodukte von aromatischen Sulfonsäuren mit Formaldehyd, wie Kondensationsprodukte aus Formaldehyd und Alkylnaphthalinsulfonsäuren oder aus Formaldehyd, Naphthalinsulfonsäuren und/oder Benzolsulfonsäuren, Kondensationsprodukte aus gegebenenfalls substituiertem Phenol mit Formaldehyd und Natriumbisulfit. Geeignet sind außerdem oberflächenaktive Mittel aus der Gruppe der Sulfobernsteinsäureester sowie Alkylbenzolsulfonate. Außerdem ionisch modifizierte, insbesondere sulfatierte oder carboxilierte, alkoxylierte Fettsäurealkohole oder deren Salze. Als alkoxylierte Fettsäurealkohole werden insbesondere solche mit 5 bis 120, vorzugsweise 5 bis 60, insbesondere mit 5 bis 30 Mol Ethylenoxid versehene C₆-C₂₂-Fettsäurealkohole, die gesättigt oder ungesättigt sind, verstanden. Weiterhin kommen vor allem Ligninsulfonate in Betracht, z.B. solche, die nach dem Sulfit- oder Kraft-Verfahren gewonnen werden. Vorzugsweise handelt es sich um Produkte, die zum Teil hydrolysiert, oxidiert, propoxyliert, sulfoniert, sulfomethyliert oder desulfoniert und nach bekannten Verfahren fraktioniert werden, z.B. nach dem Molekulargewicht oder nach dem Sulfonierungsgrad. Auch Mischungen aus Sulfit- und Kraftligninsulfonaten sind gut wirksam. Besonders geeignet sind Ligninsulfonate mit einem durchschnittlichen Molekulargewicht zwischen 1 000 und 100 000 g/mol, einem Gehalt an aktivem Ligninsulfonat von mindestens 80 Gew.-% und vorzugsweise mit niedrigem Gehalt an mehrwertigen Kationen. Der Sulfonierungsgrad kann in weiten Grenzen variieren.

Als nichtionische oberflächenaktive Mittel kommen beispielsweise in Frage: Umsetzungsprodukte von Alkylenoxiden mit alkylierbaren Verbindungen, wie z.B. Fettalkoholen, Fettaminen, Fettsäuren, Phenolen, Alkylphenolen, Arylalkylphenolen, wie Styrol-Phenol-Kondensate, Carbonsäureamiden und Harzsäuren. Hierbei handelt es sich z.B. um Ethylenoxidaddukte aus der Klasse der Umsetzungsprodukte von Ethylenoxid mit:
1) gesättigten und/oder ungesättigten Fettalkoholen mit 6 bis 22 C-Atomen oder
2) Alkylphenolen mit 4 bis 12 C-Atomen im Alkylrest oder
3) gesättigten und/oder ungesättigten Fettaminen mit 14 bis 20 C-Atomen oder
4) gesättigten und/oder ungesättigten Fettsäuren mit 14 bis 20 C-Atomen oder
5) hydrierte und/oder unhydrierte Harzsäuren.

Als Ethylenoxid-Addukte kommen insbesondere die unter 1) bis 5) genannten alkylierbaren Verbindungen mit 5 bis 120, insbesondere 5 bis 100, insbesondere 5 bis 60, besonders bevorzugt 5 bis 30 Mol Ethylenoxid in Frage.

Als oberflächenaktive Mittel eignen sich ebenfalls die aus DE-A 19 712 486 oder aus DE-A 19 535 246 bekannten Ester des Alkoxylierungsproduktes der Formel (X), die der Formel (XI) entsprechen sowie diese gegebenenfalls in Mischung mit den zugrundeliegenden Verbindungen der Formel (X). Das Alkoxylierungsprodukt eines Styrol-Phenol-Kondensats der Formel (X) ist wie nachfolgend definiert: 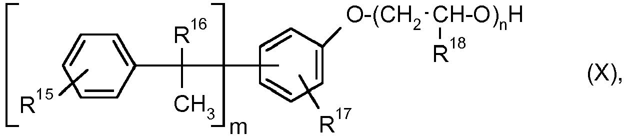 in der
- R¹⁵: Wasserstoff oder C₁-C₄-Alkyl bedeutet,
- R¹⁶: für Wasserstoff oder CH₃ steht,
- R¹⁷: Wasserstoff, C₁-C₄-Alkyl, C₁-C₄-Alkoxy, C₁-C₄-Alkoxycarbonyl oder Phenyl bedeutet,
- m: eine Zahl von 1 bis 4 bedeutet,
- n: eine Zahl von 6 bis 120 bedeutet,
- R¹⁸: für jede durch n indizierte Einheit gleich oder verschieden ist und für Wasserstoff, CH₃ oder Phenyl steht, wobei im Falle der Mitanwesenheit von CH₃ in den verschiedenen -(-CH₂-CH(R¹⁸)-O-)-Gruppen in 0 bis 60 % des Gesamtwertes von n R¹⁸ für CH₃ und in 100 bis 40 % des Gesamtwertes von n R¹⁸ für Wasserstoff steht und wobei im Falle der Mitanwesenheit von Phenyl in den verschiedenen -(-CH₂-CH(R¹⁸)-O-)-Gruppen in 0 bis 40 % des Gesamtwertes von n R¹⁸ für Phenyl und in 100 bis 60 % des Gesamtwertes von n R¹⁸ für Wasserstoff steht.

Die Ester der Alkoxylierungsprodukte (X) entsprechen der Formel (XI) 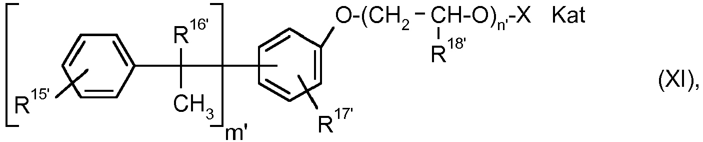 in der
R^{15'}, R^{16'}, R^{17'}, R^{18'}, m' und n' den Bedeutungsumfang von R¹⁵, R¹⁶, R¹⁷, R¹⁸, m bzw. n, jedoch unabhängig hiervon, annehmen,
X die Gruppe -SO₃, -SO₂, -PO₃ oder -CO-(R¹⁹)-COO bedeutet,
Kat ein Kation aus der Gruppe von H, Li, Na, K, NH₄ oder HO-CH₂CH₂-NH₃ ist, wobei im Falle von X = -PO₃ zwei Kat vorliegen und
R¹⁹ für einen zweiwertigen aliphatischen oder aromatischen Rest steht, vorzugsweise für C₁-C₄-Alkylen, insbesondere Ethylen, C₂-C₄- einfach ungesättigte Reste, insbesondere Acetylen oder gegebenenfalls substituiertes Phenylen, insbesondere ortho-Phenylen steht, wobei als mögliche Substituenten vorzugsweise C₁-C₄-Alkyl, C₁-C₄-Alkoxy, C₁-C₄-Alkoxycarbonyl oder Phenyl in Frage kommen.

Als ein bevorzugtes oberflächenaktive Mittel wird die Verbindung der Formel (XI) eingesetzt. Vorzugsweise eine Verbindung der Formel (XI), worin X einen Rest der Formel-CO-(R¹⁹)-COO- bedeutet und R¹⁹ die obige Bedeutung besitzt.

Bevorzugt ist es ebenfalls als oberflächenaktive Mittel eine Verbindung der Formel (XI) zusammen mit einer Verbindung der Formel (X) einzusetzen. Vorzugsweise enthält das oberflächenaktive Mittel in diesem Fall 5 bis 99 Gew.-% der Verbindung (XI) und 1 bis 95 Gew.-% der Verbindung (X).

Das oberflächenaktive Mittel der Komponente (c) wird vorzugsweise in einer Menge von 0,1 bis 100 Gew.-%, insbesondere 0,5 bis 60 Gew.-%, bezogen auf das eingesetzte erfindungsgemäße Metallazopigment, in der Pigmentpräparation, verwendet.

Selbstverständlich kann die erfindungsgemäße Pigmentpräparation noch weitere Zusätze enthalten. So können beispielsweise die Viskosität einer wässrigen Suspension erniedrigende und/oder den Feststoffgehalt erhöhende Zusätze wie beispielsweise Carbonsäure- und Sulfonsäureamide in einer Menge von bis zu 10 Gew.-%, bezogen auf die Pigmentpräparation zugesetzt werden.

Weitere Zusätze sind beispielsweise anorganische und organische Basen sowie für Pigmentpräparation übliche Zusätze.

Als Basen sind zu nennen: Alkalihydroxide, wie beispielsweise NaOH, KOH oder organische Amine wie Alkylamine, insbesondere Alkanolamine oder Alkylalkanolamine.

Als besonders bevorzugt sind zu nennen Methylamin, Dimethylamin, Trimethylamin, Ethanolamin, n-Propanolamin, n-Butanolamin, Diethanolamin, Triethanolamin, Methylethanolamin oder Dimethylethanolamin.

Als Carbonsäure- und Sulfonsäureamide sind beispielsweise geeignet: Harnstoff und substituierte Harnstoffe wie Phenylharnstoff, Dodecylharnstoff und andere; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Die Base ist gegebenenfalls bis zu einer Menge von 20 Gew.-%, vorzugsweise bis 10 Gew.-%, bezogen auf das Pigment enthalten.

Weiterhin können die erfindungsgemäßen Pigmentpräparationen herstellungsbedingt noch anorganische und/oder organische Salze enthalten.

Die erfindungsgemäßen Pigmentpräparationen sind vorzugsweise bei Raumtemperatur fest. Insbesondere liegen die erfindungsgemäßen Pigmentpräparationen als Pulver oder Granulate vor.

Die erfindungsgemäßen Pigmentpräparationen eignen sich hervorragend für alle Pigmentanwendungszwecke.

Weiterer Gegenstand der vorliegenden Erfindung ist die Verwendung mindestens eines erfindungsgemäßen Metallazopigments oder einer erfindungsgemäßen Pigmentpräparation zum Pigmentieren von Lacken aller Art für die Herstellung von Druckfarben, Leimfarben oder Binderfarben, für die Massefärbung von Papier, für die Massefärbung von synthetischen, halbsynthetischen oder natürlichen makromolekularen Stoffen, wie z.B. Polyvinylchlorid, Polystyrol, Polyamid, Polyethylen oder Polypropylen. Sie können auch für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier verwendet werden. Aus diesen Pigmenten können feinteilige, stabile, wässrige Pigmentierungen von Dispersions- und Anstrichfarben, die für die Papierfärbung, für den Pigmentdruck von Textilien, für den Laminatdruck oder für die Spinnfärbung von Viskose brauchbar sind, durch Mahlen oder Kneten in Gegenwart von nichtionogenen, anionischen oder kationischen Tensiden hergestellt werden.

Die erfindungsgemäßen Metallazopigmente eignen sich weiterhin hervorragend für Ink Jet Anwendungen und für Farbfilter für Flüssigkristallanzeigen.

In einer ebenfalls bevorzugten Ausführungsform enthalten die erfindungsgemäßen Pigmentpräparationen wenigstens eine organische Verbindung (d) ausgewählt aus der Gruppe der Terpene, Terpenoide, Fettsäuren, Fettsäureester und der Homo- oder Copolymere, wie statistische- oder Block-Copolymere mit einer Löslichkeit in pH neutralem Wasser bei 20°C von weniger als 1 g/l, insbesondere weniger als 0,1 g/l. Die organische Verbindung (d) ist vorzugsweise bei Raumtemperatur (20°C) unter Normalatmosphäre fest oder flüssig und weist im Falle, dass sie flüssig ist, einen Siedepunkt von vorzugsweise >100°C, insbesondere >150°C auf.

Bevorzugte Polymere besitzen sowohl einen hydrophilen wie auch einen hydrophoben vorzugsweise polymeren Molekülteil. Beispiele derartiger Polymere sind statistische Copolymere auf Basis von Fettsäuren oder langkettigen C₁₂-C₂₂-Kohlenwasserstoffen und Polyalkylenglykolen, insbesondere Polyethylenglykol. Ferner Block-Copolymere auf Basis von (Poly)Hydroxy Fettsäuren und Polyalkylenglykol, insbesondere Polyethylenglykol, sowie Pfropf-Copolymere auf Basis von Poly(meth)acrylat und Polyalkylenglykol, insbesondere Polyethylenglykol.

Als bevorzugte Verbindungen aus der Gruppe der Terpene, Terpenoide, Fettsäuren und Fettsäureester seien genannt: Ocimen, Myrcen, Geraniol, Nerol, Linalool, Citronellol, Geranial, Citronellal, Neral, Limonen, Menthol, beispielsweise (-)-Menthol, Menthon oder bicyclische Monoterpene, gesättigte und ungesättigte Fettsäuren mit 6 bis 22 C-Atomen, wie beispielsweise Ölsäure, Linolsäure und Linolensäure oder Mischungen davon.

Als organische Verbindungen der Komponente (d) kommen ferner auch die oben genannten Adduktbildner infrage soweit sie den für die Verbindung der Komponente (d) gewünschten Kriterien gehorchen.

Besonders bevorzugte Pigmentpräparationen enthalten:

| | |
|---|---|
| 50 - 99 Gew.-% | an wenigstens einem erfindungsgemäßen Metallazopigment und |
| 1 - 50 Gew.-% | vorzugsweise 2 bis 50 Gew.-% an wenigstens einer Verbindung der Komponente (d). |

Gegebenenfalls enthält die erfindungsgemäße Pigmentpräparation zusätzlich ein oberflächenaktives Mittel (c).

Besonders bevorzugt bestehen die erfindungsgemäßen Präparationen zu mehr als 90 Gew.-%, vorzugsweise mehr als 95 Gew.-% und insbesondere mehr als 97 Gew.-% aus mindestens einem erfindungsgemäßen Metallazopigment, mindestens einer organischen Verbindung der Komponente (d) und gegebenenfalls mindestens einem oberflächenaktiven Mittel der Komponente (c) und gegebenenfalls mindestens einer Base.

Die erfindungsgemäßen Pigmentpräparationen dieser Zusammensetzung eignen sich insbesondere zur Pigmentierung von Ink Jet Tinten und von Farbfiltern für Flüssigkristallanzeigen.

Ein weiterer Gegenstand der vorliegenden Erfindung ist ein Verfahren zur Herstellung der erfindungsgemäßen Pigmentpräparationen das dadurch gekennzeichnet ist, dass man mindestens ein erfindungsgemäßes Metallazopigment, und mindestens einen Hilfs- oder Zusatzstoff, insbesondere mindestens eine organischen Verbindung der Komponente (d) und gegebenenfalls mindestens ein oberflächenaktives Mittel der Komponente (c) und gegebenenfalls mindestens eine Base, miteinander vermischt.

Ebenfalls Gegenstand der vorliegenden Erfindung ist die Verwendung der erfindungsgemäßen Metallazopigmente oder der erfindungsgemäßen Pigmentpräparationen zur Herstellung von Farbfiltern für Flüssigkristallanzeigen. Im Folgenden sei diese Verwendung am Beispiel der Pigment-Dispersionsmethode nach dem Photolackverfahren beschrieben.

Die erfindungsgemäße Verwendung der erfindungsgemäßen Pigmentpräparationen zur Herstellung von Farbfiltern ist beispielsweise dadurch gekennzeichnet, dass mindestens ein erfindungsgemäßes Metallazopigment oder eine erfindungsgemäße Pigmentpräparation, insbesondere feste Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5 % <1000 nm, vorzugsweise 95 % <500 nm und insbesondere 90 % <200 nm nasszerkleinert wird.

Als Nasszerkleinerungsverfahren kommen beispielsweise Rührer- oder Dissolverdispergierung, Mahlen mittels Rührwerkskugel- oder -perlmühlen, Kneter, Walzenstuhl, Hochdruckhomogenisierung oder Ultraschalldispergierung in Frage.

Während der Dispergierbehandlung oder im Anschluss daran erfolgt die Zugabe von mindestens einem photohärtbaren Monomeren und einem Photoinitiator. Im Anschluss an die Dispergierung kann noch weiteres Bindemittelharz, Lösungsmittel oder für Photolacke übliche Zuschlagstoffe eingebracht werden, wie es für die gewünschte photosensitive Beschichtungsmitteleinstellung (Photolack) zur Herstellung der Farbfilter erforderlich ist.

Im Rahmen dieser Erfindung wird unter Photolack eine Präparation verstanden, die wenigstens ein photohärtbares Monomer und einen Photoinitiator enthält.

Gegenstand der vorliegenden Erfindung ist auch ein Verfahren zur Herstellung von Farbfiltern für Flüssigkristallanzeigen das dadurch gekennzeichnet ist, dass man mindestens ein erfindungsgemäßes Metallazopigment oder eine erfindungsgemäße Pigmentpräparation, gegebenenfalls mit einem Bindemittelharz und einem organischen Lösungsmittel, gegebenenfalls unter Zusatz eines Dispergiermittels, homogenisiert und anschließend kontinuierlich oder diskontinuierlich auf eine Teilchengröße nach Anzahl (elektronenmikroskopische Bestimmung) von 99,5% <1000 nm, nasszerkleinert und während der Dispergierbehandlung oder im Anschluss daran mindestens ein photohärtbares Monomer und einem Photoinitiator zugibt.

Als mögliche Dispergiermittel kommen allgemein handelsübliche, für diesen Anwendungszweck geeignete Dispergiermittel wie beispielsweise polymere, ionogene oder nicht-ionogene Dispergiermittel bspw. auf Basis von Polycarbonsäuren oder Polysulfonsäuren, sowie Polyethylenoxid-Polypropylenoxid-Block-Copolymere in Betracht. Ferner können auch Derivate organischer Farbstoffe als Dispergiermittel oder Co-Dispergiermittel verwendet werden.

Bei der Herstellung der Farbfilter fallen daher "Zubereitungen" an, die bezogen auf die Zubereitung enthalten:
- wenigstens ein erfindungsgemäßes Metallazopigment,
- gegebenenfalls ein Bindemittelharz,
- wenigstens ein organisches Lösungsmittel sowie
- gegebenenfalls ein Dispergiermittel.

In einer bevorzugten Ausführungsform enthält die Zubereitung (Angaben bezogen auf Zubereitung):

| | |
|---|---|
| 1 - 50 Gew.-% | eines erfindungsgemäßen Metallazopigments |
| 0 - 20 Gew.-% | Bindemittelharz |
| 0 - 20 Gew.-% | Dispergiermittel |
| 10 - 94 Gew.-% | organisches Lösungsmittel |

Die Beschichtung des Photolackes auf eine Platte zur Erzeugung der gefärbten Bildelementmuster kann entweder durch direkten oder indirekten Auftrag geschehen. Als Auftragsmethoden seien bspw. genannt: Roller-Coating, Spin-Coating, Spray-Coating, Dip-Coating und Air-Knife-Coating.

Als Platten kommen je nach Verwendung beispielsweise in Frage: transparente Gläser wie weiße oder blaue Glasplatte, mit Silikat beschichtete blaue Glasplatte, Kunstharzplatte oder -filme auf Basis von z.B. Polyester-, Polycarbonat-, Acryl-, oder Vinylchloridharz, ferner Metallplatten auf Basis von Aluminium, Kupfer, Nickel, oder Stahl sowie Keramikplatten oder Halbleiterplatten mit aufgebrachten photoelektrischen Transferelementen.

Die Auftragung erfolgt im Allgemeinen so, dass die Schichtdicke der erhaltenen photosensitiven Schicht bei 0,1 bis 10 µm liegt.

Im Anschluss an den Auftrag kann eine thermische Trocknung der Schicht erfolgen.

Die Belichtung erfolgt vorzugsweise, indem die photosensitive Schicht einem aktiven Lichtstrahl vorzugsweise in Form eines Bildmusters mittels Photomaske ausgesetzt wird. Hierdurch wird an
den belichteten Stellen die Schicht gehärtet. Geeignete Lichtquellen sind z.B.: Hochdruck- und Ultrahochdruckquecksilberdampflampe, Xenon-, Metallhalogenid-, Fluoreszenzlampe sowie Laserstrahl im sichtbaren Bereich.

Durch die Entwicklung im Anschluss an die Belichtung wird der unbelichtete Teil der Beschichtung entfernt und man erhält die gewünschte Bildmusterform der Farbelemente. Übliche Entwicklungsmethoden umfassen das Besprühen mit oder Tauchen in wässrige alkalische Entwicklerlösung oder in ein organisches Lösungsmittel, das anorganische Alkali wie z.B. Natrium- oder Kaliumhydroxid, Natriummetasilikat oder organische Basen wie Monoethanolamin, Diethanolamin, Triethanolamin, Triethylamin oder deren Salze enthält.

Nach der Entwicklung erfolgt in der Regel eine thermische Nachtrocknung/-härtung der Bildmuster.

Die erfindungsgemäße Verwendung der Metallazopigmente ist vorzugsweise dadurch gekennzeichnet, dass diese alleine oder in Mischung mit anderen, für die Herstellung von Farbfiltern üblichen, Pigmenten in den Farbfiltern bzw. Pigmentpräparationen oder Zubereitungen für Farbfilter eingesetzt werden.

Diese "anderen Pigmente" können sowohl andere Metallsalze einer Azo-Verbindung der Formel (I) oder darauf basierende Pigmentpräparationen sein als auch andere anorganische oder organische Pigmente.

Hinsichtlich der Auswahl anderer gegebenenfalls mitzuverwendender Pigmente besteht erfindungsgemäß keine Einschränkung. Es kommen sowohl anorganische als auch organische Pigmente in Frage.

Bevorzugte organische Pigmente sind z.B. solche der Monoazo-, Disazo-, verlackte Azo-, β-Naphthol-, Napthol AS-, Benzimidazolon-, Disazokondensations-, Azometallkomplex-, Isoindolin- und Isoindolinon-Reihe, ferner polycyclische Pigmente wie z.B. aus der Phthalocyanin-, Chinacridon-, Perylen-, Perinon-, Thioindigo-, Anthrachinon-, Dioxazin-, Chinophthalon- und Diketopyrrolopyrrol-Reihe. Außerdem verlackte Farbstoffe wie Ca-, Mg- und Al-Lacke von sulfonsäure- oder carbonsäuregruppenhaltigen Farbstoffen.

Beispiele für gegebenenfalls mitzuverwendende andere organische Pigmente sind:
Colour Index Pigment Yellow 12, 13, 14, 17, 20, 24, 74, 83, 86, 93, 94, 109, 110, 117, 125, 137, 138, 139, 147, 148, 150, 153, 154, 166, 173, 185, oder
Colour Index Pigment Orange 13, 31, 36, 38, 40, 42, 43, 51, 55, 59, 61, 64, 65, 71, 72, 73 oder
Colour Index Pigment Red 9, 97, 122, 123, 144, 149, 166, 168, 177, 180, 192, 215, 216, 224, 254, 272, oder
Colour Index Pigment Green 7, 10, 36, 37, 45, 58 oder
Colour Index Pigment Blue 15, 15:1, 15:2, 15:3, 15:4, 15:6, 16 sowie
Colour Index Pigment Violett 19, 23.

Darüber hinaus können auch lösliche organische Farbstoffe in Verbindung mit den erfindungsgemäßen neuen Pigmenten eingesetzt werden.

Sofern "andere Pigmente" zusätzlich eingesetzt werden, beträgt der Anteil an erfindungsgemäßem Metallazopigment vorzugsweise 1-99 Gew.-%, insbesondere 20-80 Gew.-% bezogen auf die eingesetzte Gesamtmenge aller Pigmente. Besonders bevorzugt sind die erfindungsgemäßen Pigmentpräparationen sowie Zubereitungen, enthaltend mindestens ein erfindungsgemäßes Metallazopigment und C.I. Pigment Green 36 und/oder C.I. Pigment Green 58 im Verhältnis von 20 bis 80 Gew.-% Metallazopigment zu 80 bis 20 Gew.-% C.I. Pigment Green 36 und/oder C.I. Pigment Green 58, vorzugsweise von 40 bis 60 Gew.- % zu 60 bis 40 Gew.-%.

Hinsichtlich der Bindemittelharze, die zusammen mit dem "Pigment" oder darauf basierender Pigmentpräparationen in Farbfiltern bzw. in den Zubereitungen zur Herstellung von Farbfiltern z.B. nach der Pigment-Dispersionsmethode eingesetzt werden können, besteht erfindungsgemäß keine besondere Einschränkung, insbesondere kommen für die Anwendung in Farbfiltern an sich bekannte filmbildende Harze in Frage.

Beispielsweise kommen Bindemittelharze aus der Gruppe der Celluloseharze wie Carboxymethylhydroxyethylcellulose und Hydroxyethylcellulose, Acrylharze, Alkydharze, Melaminharze, Epoxidharze, Polyvinylalkohole, Polyvinylpyrrolidone, Polyamide, Polyamidimine, Polyimide,

Polyimidvorstufen wie solche der Formel (14), offenbart in JP-A 11 217 514 und deren Veresterungsprodukte in Frage.

Als solche sind beispielsweise Umsetzungsprodukte von Tetracarbonsäuredianhydrid mit Diaminen zu nennen.

Als Bindemittelharze kommen auch solche in Frage, die photopolymerisierbare, ungesättigte Bindungen enthalten. Die Bindemittelharze können beispielsweise solche aus der Gruppe der Acrylharze aufgebaut sein. Dabei sind insbesondere Homo- und Copolymere polymerisierbarer Monomere zu nennen wie z.B. (Meth)acrylsäuremethylester, (Meth)acrylsäureethylester, (Meth)acrylsäurepropylester, (Meth)acrylsäurebutylester, Styrol und Styrolderivate, ferner Copolymere zwischen carboxylgruppentragenden polymerisierbaren Monomeren wie (Meth)acrylsäure, Itaconsäure, Maleinsäure, Maleinsäureanhydrid, Maleinsäuremonoalkylester, insbesondere mit Alkyl von 1 bis 12 C-Atomen, und polymerisierbare Monomere wie (Meth)acrylsäure, Styrol und Styrolderi-vate, wie z.B. α-Methylstyrol, m- oder p-Methoxystyrol, p-Hydroxystyrol. Als Beispiele seien genannt Umsetzungsprodukte von carboxylgruppenhaltigen polymeren Verbindungen mit Verbindungen, die jeweils einen Oxiranring und eine ethylenisch ungesättigte Verbindung enthalten wie z.B. Glycidyl(meth)acrylat, Acrylglycidylether und Itaconsäuremonoalkylglycidylether usw., ferner Umsetzungsprodukte von carboxylgruppenhaltigen polymeren Verbindungen mit Verbindungen, die jeweils eine Hydroxylgruppe und eine ethylenisch ungesättigte Verbindung (ungesättigte Alkohole) enthalten wie Allylalkohol, 2-Buten-4-ol, Oleylalkohol, 2-Hydroxyethyl-(meth)acrylat, N-Methylolacrylamid usw.;

weiterhin können derartige Bindemittelharze auch ungesättigte Verbindungen, die freie Isocyanatgruppen besitzen, enthalten.

Im Allgemeinen liegt die Äquivalenz der Ungesättigtheit (Molgewicht Bindemittelharz pro ungesättigte Verbindung) der genannten Bindemittelharze bei 200 bis 3 000, insbesondere 230 bis 1 000, um sowohl eine ausreichende Photopolymerisierbarkeit und Härte des Films zu erreichen. Der Säurewert liegt im Allgemeinen bei 20 bis 300, insbesondere 40 bis 200, um eine genügende Alkali-Entwicklungsfähigkeit nach der Belichtung des Films zu erzielen.

Das mittlere Molgewicht der einzusetzenden Bindemittelharze liegt zwischen 1 500 und 200 000, insbesondere 10 000 bis 50 000 g/mol.

Die bei der erfindungsgemäßen Verwendung der Pigmentpräparationen für Farbfilter eingesetzten organischen Lösungsmittel sind z.B. Ketone, Alkylenglykolether, Alkohole und aromatische Verbindungen. Beispiele aus der Gruppe der Ketone sind: Aceton, Methylethylketon, Cyclohexanon etc.; aus der Gruppe der Alkylenglykolether: Methylcellosolve (Ethylenglykolmonomethylether), Butylcellosolve (Etylenglykolmonobutylether) Methylcellosolveacetat, Ethylcellosolveacetat, Butylcellosolveacetat, Ethylenglykolmonopropylether, Ethylenglykolmonohexylether, Ethylenglykoldimethylether, Diethylenglykolethylether, Diethylenglykoldiethylether, Propylenglykolmonomethylether, Propylenglykolmonoethylether, Propylenglykolmonopropylether, Propylenglykolmonobutylether, Propylenglykolmonomethyletheracetat, Diethylenglykolmethyletheracetat, Diethylenglykolethyletheracetat, Diethylenglykolpropyletheracetat, Diethylenglykolisopropyletheracetat, Diethylenglykolbutyletheracetat, Diethylenglykol-t-butyletheracetat, Triethylenglykolmethyletheracetat, Triethylenglykolethyletheracetat, Triethylenglykolpropyletheracetat, Triethylenglykolisopropyletheracetat, Triethylenglykolbutyletheracetat, Triethylenglykol-t-butyletheracetat, etc.; aus der Gruppe der Alkohole: Methylalkohol, Ethylalkohol, Isopropylalkohol, n-Butylalkohol, 3-Methyl-3-methoxybutanol, etc.; aus der Gruppe der aromatischen Lösungsmittel Benzol, Toluol, Xylol, N-Methyl-2-Pyrrolidon, N-Hydroxymethyl-2-Essigsäureethylester, etc.

Weitere andere Lösungsmittel sind 1,2-Propandioldiacetat, 3-Methyl-3-methoxybutylacetat, Essigsäureethylester, Tetrahydrofuran, etc. Die Lösungsmittel können einzeln oder in Gemischen untereinander eingesetzt werden.

Die Erfindung betrifft weiterhin einen Photolack, enthaltend wenigstens ein erfindungsgemäßes Metallazopigment oder wenigstens eine erfindungsgemäße Pigmentpräparation und wenigstens ein photohärtbares Monomer sowie wenigstens einen Photoinitiator.

Die photohärtbaren Monomere enthalten im Molekül wenigstens eine reaktive Doppelbindung und gegebenenfalls andere reaktive Gruppen.

Als photohärtbare Monomere seien in diesem Zusammenhang insbesondere reaktive Lösungsmittel bzw. sog. Reaktivverdünner verstanden z.B. aus der Gruppe der mono-, di- , tri- und multifunktionelle Acrylate und Methacrylate, Vinylether, sowie Glycidylether. Als zusätzlich enthaltene reaktive Gruppen kommen in Frage Allyl-, Hydroxy-, Phosphat-, Urethan-, sek. Amin- und N-Alkoxymethylgruppen.

Derartige Monomere sind dem Fachmann bekannt und beispielsweise in *[*Römpp Lexikon, Lacke und Druckfarben, Dr. Ulrich Zorll, Thieme Verlag Stuttgart-New York, 1998, S. 491/492*]* aufgeführt.

Die Auswahl der Monomere richtet sich insbesondere nach der Art und Intensität der verwendeten Strahlenart der Belichtung, der gewünschten Reaktion mit dem Photoinitiator und den Filmeigenschaften. Es können auch Kombinationen von Monomeren eingesetzt werden.

Als Photoreaktionsstarter oder Photoinitiatoren seien Verbindungen verstanden, die infolge der Absorption sichtbarer oder ultravioletter Strahlung reaktive Zwischenprodukte bilden, die eine Polymerisationsreaktion beispielsweise der oben genannten Monomeren und/oder Bindemittelharze auslösen können. Photoreaktionsstarter sind ebenfalls allgemein bekannt und können ebenfalls aus *[*Römpp Lexikon, Lacke und Druckfarben, Dr. Ulrich Zorll, Thieme Verlag Stuttgart-New York, 1998, S. 445/446*]* entnommen werden.

Erfindungsgemäß besteht keine Einschränkung hinsichtlich der einzusetzenden photohärtbaren Monomeren oder Photoinitiatoren.

Die Erfindung betrifft bevorzugt Photolacke enthaltend
A) wenigstens ein erfindungsgemäßes Metallazopigment, insbesondere in Mischung mit anderen Pigmenten, vorzugsweise C.I. Pigment Green 36 und/oder Pigment Green 58 oder eine darauf basierende erfindungsgemäße Pigmentpräparation,
B1) wenigstens ein photohärtbares Monomer,
B2) wenigstens einen Photoinitiator,
C1) gegebenenfalls ein organisches Lösungsmittel,
D) gegebenenfalls ein Dispergiermittel,
E) gegebenenfalls ein Bindemittelharz,
sowie gegebenenfalls weitere Zusätze.

Erfindungsgemäß besteht auch keine Einschränkung hinsichtlich der Technologie zur Erzeugung der gefärbten Bildelementmuster auf Basis der erfindungsgemäß zu verwendenden Pigmente oder feste Pigmentpräparationen. Neben dem oben beschriebenen photolithographischen Verfahren sind andere Verfahren wie Offset-Druck, chemisches Ätzen oder Ink Jet Druck ebenso geeignet. Die Auswahl der geeigneten Bindemittelharze und Lösungsmittel bzw. Pigment-Trägermedien sowie weitere Zusätze sind auf das jeweilige Verfahren abzustimmen. Beim Ink Jet Verfahren, worunter sowohl der thermische als auch mechanische und piezo-mechanische Ink Jet Druck verstanden werden, kommen neben rein organischen auch wässrig-organische Trägermedien für die Pigmente und gegebenenfalls Bindemittelharze in Frage, wässrig-organische Trägermedien werden sogar bevorzugt.
Die folgenden Beispiele sollen die vorliegende Erfindung erläutern ohne sie jedoch darauf zu beschränken.

### Beispiele

### Herstellung der Vorstufe Azobarbitursäure (Vorschrift 1)

In 1100 g destillierten Wasser von 85°C wurden 46,2 g Diazobarbitursäure und 38,4 g Barbitursäure eingetragen. Anschließend wurde mit wässriger Kalilauge auf ca. pH 5 gestellt und 90 Min. nachgerührt.

### Beispiel 1:

Eine nach Vorschrift 1 hergestellte Azobarbitursäure wurde bei 82°C mit 1500 g destilliertem Wasser versetzt. Anschließend wurde 10 g 30%ige Salzsäure zugetropft. Danach wurden 79,4 g Melamin eingetragen. Anschließend wurde 0,3 Mol einer ca. 25%igen Nickelchlorid-Lösung zugetropft. Nach 3h bei 82°C wurde mit KOH auf ca. pH 5,5 gestellt. Danach wurde bei 90°C mit ca. 100 g destilliertem Wasser verdünnt. Anschließend wurde 21 g 30%ige Salzsäure zugetropft und 12h bei 90°C getempert. Danach wurde mit wässriger Kalilauge auf ca. pH 5 gestellt. Anschließend wurde das Pigment auf einer Saugnutsche isoliert, gewaschen und bei 80°C im Vakuumtrockenschrank getrocknet und in einer üblichen Labormühle ca. 2 Minuten gemahlen. (= Pigment 1, nicht erfindungsgemäß)

### Beispiele 2 bis 71

Zur Herstellung der erfindungsgemäßen Pigmente 26 bis 37 sowie der nicht erfindungsgemäßen Pigmente 2 bis 25, 38 bis 71 wurde jeweils analog zu Beispiel 1 vorgegangen.

Es wurde jeweils eine nach Vorschrift 1 hergestellte Azobarbitursäure bei 82°C mit 5000 g destilliertem Wasser versetzt und danach 252,2 g Melamin eingetragen. Anschließend wurde anstatt der Nickelchlorid-Lösung des Beispiels 1 jeweils eine Metallsalzlösung, wie in den folgenden Beispielen angegeben, zugetropft. Die Aufarbeitung und Isolierung, Trocknung und Mahlung des jeweiligen Pigments erfolgte bei allen Beispielen analog zu der in Beispiel 1 angegebenen Vorschrift.

### Beispiel 2:

Es wurde eine Mischung aus 0,285 Mol einer ca. 25%igen Nickelchlorid-Lösung und 0,010 Mol einer ca. 10%igen Gadolinium(III)-chlorid- Lösung zugetropft.

### Beispiel 3:

Es wurde eine Mischung aus 0,240 Mol einer ca. 25%igen Nickelchlorid-Lösung und 0,040 Mol einer ca. 10%igen Gadolinium(III)-chlorid- Lösung zugetropft.

### Beispiel 4:

Es wurde eine Mischung aus 0,285 Mol einer ca. 25%igen Nickelchlorid-Lösung und 0,010 Mol einer ca. 10%igen Holmium(III)-chlorid-Lösung zugetropft.

### Beispiel 5:

Es wurde eine Mischung aus 0,240 Mol einer ca. 25%igen Nickelchlorid-Lösung und 0,040 Mol einer ca. 10%igen Holmium(III)-chlorid-Lösung zugetropft.

### Beispiel 6:

Es wurde eine Mischung aus 0,285 Mol einer ca. 25%igen Nickelchlorid-Lösung und 0,010 Mol einer ca. 10%igen Samarium(III)-chlorid-Lösung zugetropft.

### Beispiel 7:

Es wurde eine Mischung aus 0,240 Mol einer ca. 25%igen Nickelchlorid-Lösung und 0,040 Mol einer ca. 10%igen Samarium(III)-chlorid-Lösung zugetropft.

### Beispiel 8:

Es wurde eine Mischung aus 0,285 Mol einer ca. 25%igen Nickelchlorid-Lösung und 0,010 Mol einer ca. 10%igen Terbium(III)-chlorid-Lösung zugetropft.

### Beispiel 9:

Es wurde eine Mischung aus 0,240 Mol einer ca. 25%igen Nickelchlorid-Lösung und 0,040 Mol einer ca. 10%igen Terbium(III)-chlorid-Lösung zugetropft.

### Beispiel 10:

Es wurde eine Mischung aus 0,285 Mol einer ca. 25%igen Nickelchlorid-Lösung und 0,010 Mol einer ca. 10%igen Ytterbium(III)-chlorid-Lösung zugetropft.

### Beispiel 11:

Es wurde eine Mischung aus 0,240 Mol einer ca. 25%igen Nickelchlorid-Lösung und 0,040 Mol einer ca. 10%igen Ytterbium(III)-chlorid-Lösung zugetropft.

### Beispiel 12:

Es wurde eine Mischung aus 0,285 Mol einer ca. 25%igen Nickelchlorid-Lösung und 0,010 Mol einer ca. 10%igen Erbium(III)-chlorid-Lösung zugetropft.

### Beispiel 13:

Es wurde eine Mischung aus 0,240 Mol einer ca. 25%igen Nickelchlorid-Lösung und 0,040 Mol einer ca. 10%igen Erbium(III)-chlorid-Lösung zugetropft.

### Beispiel 14:

Es wurde eine Mischung aus 0,285 Mol einer ca. 25%igen Nickelchlorid-Lösung und 0,010 Mol einer ca. 10%igen Dysprosium(III)-chlorid-Lösung zugetropft.

### Beispiel 15:

Es wurde eine Mischung aus 0,240 Mol einer ca. 25%igen Nickelchlorid-Lösung und 0,040 Mol einer ca. 10%igen Dysprosium(III)-chlorid-Lösung zugetropft.

### Beispiel 16:

Es wurde eine Mischung aus 0,285 Mol einer ca. 25%igen Nickelchlorid-Lösung und 0,010 Mol einer ca. 10%igen Neodym(III)-chlorid-Lösung zugetropft.

### Beispiel 17:

Es wurde eine Mischung aus 0,240 Mol einer ca. 25%igen Nickelchlorid-Lösung und 0,040 Mol einer ca. 10%igen Neodym(III)-chlorid-Lösung zugetropft.

### Beispiel 18:

Es wurde eine Mischung aus 0,285 Mol einer ca. 25%igen Nickelchlorid-Lösung und 0,010 Mol einer ca. 10%igen Europium(III)-chlorid-Lösung zugetropft.

### Beispiel 19:

Es wurde eine Mischung aus 0,240 Mol einer ca. 25%igen Nickelchlorid-Lösung und 0,040 Mol einer ca. 10%igen Europium(III)-chlorid-Lösung zugetropft.

### Beispiel 20:

Es wurde eine Mischung aus 0,285 Mol einer ca. 25%igen Nickelchlorid-Lösung und 0,010 Mol einer ca. 10%igen Praseodym(III)-chlorid-Lösung zugetropft.

### Beispiel 21:

Es wurde eine Mischung aus 0,240 Mol einer ca. 25%igen Nickelchlorid-Lösung und 0,040 Mol einer ca. 10%igen Praseodym (III)-chlorid-Lösung zugetropft.

### Beispiel 22:

Es wurde eine Mischung aus 0,285 Mol einer ca. 25%igen Nickelchlorid-Lösung und 0,010 Mol einer ca. 10%igen Lanthan(III)-chlorid-Lösung zugetropft.

### Beispiel 23:

Es wurde eine Mischung aus 0,240 Mol einer ca. 25%igen Nickelchlorid-Lösung und 0,040 Mol einer ca. 10%igen Lanthan(III)-chlorid-Lösung zugetropft.

### Beispiel 24:

Es wurde eine Mischung aus 0,285 Mol einer ca. 25%igen Nickelchlorid-Lösung und 0,010 Mol einer ca. 10%igen Cer(III)-chlorid-Lösung zugetropft.

### Beispiel 25:

Es wurde eine Mischung aus 0,240 Mol einer ca. 25%igen Nickelchlorid-Lösung und 0,040 Mol einer ca. 10%igen Cer(III)-chlorid-Lösung zugetropft.

### Beispiel 26:

Es wurde eine Mischung aus 0,180 Mol einer ca. 25%igen Nickelchlorid-Lösung und 0,080 Mol einer ca. 10%igen Gadolinium(III)-chlorid-Lösung zugetropft.

### Beispiel 27:

Es wurde eine Mischung aus 0,180 Mol einer ca. 25%igen Nickelchlorid-Lösung und 0,080 Mol einer ca. 10%igen Holmium(III)-chlorid-Lösung zugetropft.

### Beispiel 28:

Es wurde eine Mischung aus 0,180 Mol einer ca. 25%igen Nickelchlorid-Lösung und 0,080 Mol einer ca. 10%igen Samarium(III)-chlorid-Lösung zugetropft.

### Beispiel 29:

Es wurde eine Mischung aus 0,180 Mol einer ca. 25%igen Nickelchlorid-Lösung und 0,080 Mol einer ca. 10%igen Terbium(III)-chlorid-Lösung zugetropft.

### Beispiel 30:

Es wurde eine Mischung aus 0,180 Mol einer ca. 25%igen Nickelchlorid-Lösung und 0,080 Mol einer ca. 10%igen Ytterbium(III)-chlorid-Lösung zugetropft.

### Beispiel 31:

Es wurde eine Mischung aus 0,180 Mol einer ca. 25%igen Nickelchlorid-Lösung und 0,080 Mol einer ca. 10%igen Erbium(III)-chlorid-Lösung zugetropft.

### Beispiel 32:

Es wurde eine Mischung aus 0,180 Mol einer ca. 25%igen Nickelchlorid-Lösung und 0,080 Mol einer ca. 10%igen Dysprosium(III)-chlorid-Lösung zugetropft.

### Beispiel 33:

Es wurde eine Mischung aus 0,180 Mol einer ca. 25%igen Nickelchlorid-Lösung und 0,080 Mol einer ca. 10%igen Neodym(III)-chlorid-Lösung zugetropft.

### Beispiel 34:

Es wurde eine Mischung aus 0,180 Mol einer ca. 25%igen Nickelchlorid-Lösung und 0,080 Mol einer ca. 10%igen Europium(III)-chlorid-Lösung zugetropft.

### Beispiel 35:

Es wurde eine Mischung aus 0,180 Mol einer ca. 25%igen Nickelchlorid-Lösung und 0,080 Mol einer ca. 10%igen Praseodym(III)-chlorid-Lösung zugetropft.

### Beispiel 36:

Es wurde eine Mischung aus 0,180 Mol einer ca. 25%igen Nickelchlorid-Lösung und 0,080 Mol einer ca. 10%igen Lanthan(III)-chlorid-Lösung zugetropft.

### Beispiel 37:

Es wurde eine Mischung aus 0,180 Mol einer ca. 25%igen Nickelchlorid-Lösung und 0,080 Mol einer ca. 10%igen Cer(III)-chlorid-Lösung zugetropft.

### Beispiel 38:

Es wurde eine Mischung aus 0,285 Mol einer ca. 25%igen Nickelchlorid-Lösung, 0,005 Mol einer ca. 10%igen Gadolinium(III)-chlorid-Lösung und 0,005 Mol einer ca. 10%igen Holmium(III)-chlorid-Lösung zugetropft.

### Beispiel 39:

Es wurde eine Mischung aus 0,264 Mol einer ca. 25%igen Nickelchlorid-Lösung, 0,008 Mol einer ca. 10%igen Gadolinium(III)-chlorid-Lösung, 0,008 Mol einer ca. 10%igenSamarium(III)-chlorid-Lösung und 0,008 Mol einer ca. 10%igen Holmium(III)-chlorid-Lösung zugetropft.

### Beispiel 40:

Es wurde eine Mischung aus 0,282 Mol einer ca. 25%igen Nickelchlorid-Lösung, 0,004 Mol einer ca. 10%igen Dysprosium(III)-chlorid-Lösung, 0,004 Mol einer ca. 10%igen Samarium(III)-chlorid-Lösung und 0,004 Mol einer ca. 10%igen Holmium(III)-chlorid-Lösung zugetropft.

### Beispiel 41:

Es wurde eine Mischung aus 0,240 Mol einer ca. 25%igen Nickelchlorid-Lösung, 0,020 Mol einer ca. 10%igen Terbium(III)-chlorid-Lösung und 0,020 Mol einer ca. 10%igen Ytterbium(III)-chlorid-Lösung zugetropft.

### Beispiel 42:

Es wurde eine Mischung aus 0,255 Mol einer ca. 25%igen Nickelchlorid-Lösung, 0,010 Mol einer ca. 10%igen Erbium(III)-chlorid-Lösung, 0,010 Mol einer ca. 10%igen Dysprosium(III)-chlorid-Lösung und 0,010 Mol einer ca. 10%igen Neodym(III)-chlorid-Lösung zugetropft.

### Beispiel 43:

Es wurde eine Mischung aus 0,285 Mol einer ca. 25%igen Nickelchlorid-Lösung, 0,005 Mol einer ca. 10%igen Gadolinium(III)-chlorid-Lösung und 0,005 Mol einer ca. 10%igen Holmium(III)-chlorid-Lösung zugetropft.

### Beispiel 44:

Es wurde eine Mischung aus 0,240 Mol einer ca. 25%igen Nickelchlorid-Lösung, 0,020 Mol einer ca. 10%igen Praseodym(III)-chlorid-Lösung und 0,020 Mol einer ca. 10%igen Lanthan(III)-chlorid-Lösung zugetropft.

### Beispiel 45:

Es wurde eine Mischung aus 0,282 Mol einer ca. 25%igen Nickelchlorid-Lösung, 0,004 Mol einer ca. 10%igen Lanthan(III)-chlorid-Lösung, 0,004 Mol einer ca. 10%igen Cer(III)-chlorid-Lösung und 0,004 Mol einer ca. 10%igen Ytterbium(III)-chlorid-Lösung zugetropft.

### Beispiel 46:

Es wurde eine Mischung aus 0,240 Mol einer ca. 25%igen Nickelchlorid-Lösung, 0,01 Mol einer ca. 10%igen Lanthan(III)-chlorid-Lösung, 0,01 Mol einer ca. 10%igen Dysprosium(III)-chlorid-Lösung, 0,01 Mol einer ca. 10%igen Praseodym(III)-chlorid-Lösung und 0,01 Mol einer ca. 10%igen Holmium(III)-chlorid-Lösung zugetropft.

### Beispiel 47:

Es wurde eine Mischung aus 0,282 Mol einer ca. 25%igen Nickelchlorid-Lösung, 0,003 Mol einer ca. 10%igen Samarium(III)-chlorid-Lösung, 0,003 Mol einer ca. 10%igen Holmium(III)-chlorid-Lösung, 0,003 Mol einer ca. 10%igen Europium(III)-chlorid-Lösung und 0,003 Mol einer ca. 10%igen Praseodym(III)-chlorid-Lösung zugetropft.

### Beispiel 48:

Es wurde eine Mischung aus 0,120 Mol einer ca. 25%igen Nickelchlorid-Lösung und 0,120 Mol einer ca. 10%igen Gadolinium(III)-chlorid-Lösung zugetropft.

### Beispiel 49:

Es wurde eine Mischung aus 0,120 Mol einer ca. 25%igen Nickelchlorid-Lösung und 0,120 Mol einer ca. 10%igen Holmium(III)-chlorid-Lösung zugetropft.

### Beispiel 50:

Es wurde eine Mischung aus 0,120 Mol einer ca. 25%igen Nickelchlorid-Lösung und 0,120 Mol einer ca. 10%igen Samarium(III)-chlorid-Lösung zugetropft.

### Beispiel 51:

Es wurde eine Mischung aus 0,120 Mol einer ca. 25%igen Nickelchlorid-Lösung und 0,120 Mol einer ca. 10%igen Terbium(III)-chlorid-Lösung zugetropft.

### Beispiel 52:

Es wurde eine Mischung aus 0,120 Mol einer ca. 25%igen Nickelchlorid-Lösung und 0,120 Mol einer ca. 10%igen Ytterbium(III)-chlorid-Lösung zugetropft.

### Beispiel 53:

Es wurde eine Mischung aus 0,120 Mol einer ca. 25%igen Nickelchlorid-Lösung und 0,120 Mol einer ca. 10%igen Erbium(III)-chlorid-Lösung zugetropft.

### Beispiel 54:

Es wurde eine Mischung aus 0,120 Mol einer ca. 25%igen Nickelchlorid-Lösung und 0,120 Mol einer ca. 10%igen Dysprosium(III)-chlorid-Lösung zugetropft.

### Beispiel 55:

Es wurde eine Mischung aus 0,120 Mol einer ca. 25%igen Nickelchlorid-Lösung und 0,120 Mol einer ca. 10%igen Neodym(III)-chlorid-Lösung zugetropft.

### Beispiel 56:

Es wurde eine Mischung aus 0,120 Mol einer ca. 25%igen Nickelchlorid-Lösung und 0,120 Mol einer ca. 10%igen Europium(III)-chlorid-Lösung zugetropft.

### Beispiel 57:

Es wurde eine Mischung aus 0,120 Mol einer ca. 25%igen Nickelchlorid-Lösung und 0,120 Mol einer ca. 10%igen Praseodym (III)-chlorid-Lösung zugetropft.

### Beispiel 58:

Es wurde eine Mischung aus 0,120 Mol einer ca. 25%igen Nickelchlorid-Lösung und 0,120 Mol einer ca. 10%igen Lanthan(III)-chlorid-Lösung zugetropft.

### Beispiel 59:

Es wurde eine Mischung aus 0,120 Mol einer ca. 25%igen Nickelchlorid-Lösung und 0,120 Mol einer ca. 10%igen Cer(III)-chlorid-Lösung zugetropft.

### Beispiel 60:

Es wurde eine Mischung aus 0,291 Mol einer ca. 25%igen Nickelchlorid-Lösung und 0,006 Mol einer ca. 10%igen Gadolinium(III)-chlorid-Lösung zugetropft.

### Beispiel 61:

Es wurde eine Mischung aus 0,291 Mol einer ca. 25%igen Nickelchlorid-Lösung und 0,006 Mol einer ca. 10%igen Holmium(III)-chlorid-Lösung zugetropft.

### Beispiel 62:

Es wurde eine Mischung aus 0,291 Mol einer ca. 25%igen Nickelchlorid-Lösung und 0,006 Mol einer ca. 10%igen Samarium(III)-chlorid-Lösung zugetropft.

### Beispiel 63:

Es wurde eine Mischung aus 0,291 Mol einer ca. 25%igen Nickelchlorid-Lösung und 0,006 Mol einer ca. 10%igen Terbium(III)-chlorid-Lösung zugetropft.

### Beispiel 64:

Es wurde eine Mischung aus 0,291 Mol einer ca. 25%igen Nickelchlorid-Lösung und 0,006 Mol einer ca. 10%igen Ytterbium(III)-chlorid-Lösung zugetropft.

### Beispiel 65:

Es wurde eine Mischung aus 0,291 Mol einer ca. 25%igen Nickelchlorid-Lösung und 0,006 Mol einer ca. 10%igen Erbium(III)-chlorid-Lösung zugetropft.

### Beispiel 66:

Es wurde eine Mischung aus 0,297 Mol einer ca. 25%igen Nickelchlorid-Lösung und 0,002 Mol einer ca. 10%igen Dysprosium(III)-chlorid-Lösung zugetropft.

### Beispiel 67:

Es wurde eine Mischung aus 0,297 Mol einer ca. 25%igen Nickelchlorid-Lösung und 0,002 Mol einer ca. 10%igen Neodym(III)-chlorid-Lösung zugetropft.

### Beispiel 68:

Es wurde eine Mischung aus 0,297 Mol einer ca. 25%igen Nickelchlorid-Lösung und 0,002 Mol einer ca. 10%igen Europium(III)-chlorid-Lösung zugetropft.

### Beispiel 69:

Es wurde eine Mischung aus 0,297 Mol einer ca. 25%igen Nickelchlorid-Lösung und 0,002 Mol einer ca. 10%igen Praseodym (III)-chlorid-Lösung zugetropft.

### Beispiel 70:

Es wurde eine Mischung aus 0,297 Mol einer ca. 25%igen Nickelchlorid-Lösung und 0,002 Mol einer ca. 10%igen Lanthan(III)-chlorid-Lösung zugetropft.

### Beispiel 71:

Es wurde eine Mischung aus 0,297 Mol einer ca. 25%igen Nickelchlorid-Lösung und 0,002 Mol einer ca. 10%igen Cer(III)-chlorid-Lösung zugetropft.

### Bestimmung der Farbstärke in PVC

Die nach den Beispielen 1 bis 71 hergestellten Pigmente 1 bis 71 wurden jeweils einer Bestimmung der Farbstärke nach folgender Methode unterzogen. Die Ergebnisse sind in Tabelle 1 aufgeführt.

Als Prüfmedium wurde ein Weich-PVC-Compound, durch Homogenisierung von 67,5% Vestolit® E7004 (Vestolit GmbH), 29,0% Hexamoll® Dinch (BASF), 2,25% Baerostab UBZ 770 (Baerlocher GmbH) und 1,25% Isocolor Pigmentpaste weiß (ISL-Chemie) mit einem Labordissolver hergestellt.

Auf einem Laborwalzwerk wurden 100 g des PVC -Compounds bei 150°C auf zwei mit 20 min⁻¹ und 18 min⁻¹ rotierenden Walzen von 150 mm Durchmesser gegeben. Zusammen mit 0,10 g Pigment wurde das entstandene Walzfell achtmal durch einen Walzenspalt von 0,10 mm geführt. Dann wurde das gleichmäßig gefärbte Walzfell bei 0,8 mm Walzenspalt abgenommen und glatt auf eine Metallfläche abgelegt. Das abgekühlte Walzfell wurde dann auf zwei unbeheizten mit 26 min⁻¹ und 24 min⁻¹ rotierenden Walzen von 110 mm Durchmesser achtmal durch einen Waltenspalt von 0,2mm gegeben. Zur Glättung der Oberfläche wurde dieses Walzfell nochmals auf die Walzen von 150°C gegeben, bei 0,8 mm abgenommen und auf glatter Fläche abkühlen gelassen. Muster dieses Fells dienten zur Bestimmung der relativen Farbstärke.

Die Berechnung der relativen Farbstärke erfolgte nach Remissionsmessung der Muster vor einem Weißhintergrund mittels Spektralphotometer mit Messgeometrie d/8 unter Normlichtart D65 und 10° Beobachter nach DIN 55986 unter Verwendung der Summe der K/S-Werte über das sichtbare Spektrum (400nm-700nm).

**Tabelle 1: (Beispiele 2-25, 38-71 sind nicht erfindungsgemäss)**

| Probe | **Einsatz Val %** | Status | Farbstärke % |
|---|---|---|---|
| Pigment 1 | 100 % Ni | nicht erfindungsgemäß | 100 |
| Pigment 2 | 5 % Gd | | 107 |
| Pigment 3 | 20% Gd | | 115 |
| Pigment 4 | 5 % Ho | | 108 |
| Pigment 5 | 20 % Ho | | 116 |
| Pigment 6 | 5 % Sm | | 105 |
| Pigment 7 | 20 % Sm | | 113 |
| Pigment 8 | 5 % Tb | | 106 |
| Pigment 9 | 20 % Tb | | 115 |
| Pigment 10 | 5 % Yb | | 105 |
| Pigment 11 | 20 % Yb | | 116 |
| Pigment 12 | 5 % Er | | 107 |
| Pigment 13 | 20 % Er | | 117 |
| Pigment 14 | 5 % Dy | | 106 |
| Pigment 15 | 20 % Dy | | 116 |
| Pigment 16 | 5 % Nd | | 107 |
| Pigment 17 | 20 % Nd | | 118 |
| Pigment 18 | 5 % Eu | | 106 |
| Pigment 19 | 20 % Eu | | 117 |
| Pigment 20 | 5 % Pr | | 108 |
| Pigment 21 | 20 % Pr | | 118 |
| Pigment 22 | 5 % La | | 105 |
| Pigment 23 | 20 % La | | 116 |
| Pigment 24 | 5 % Ce | | 106 |
| Pigment 25 | 20 % Ce | | 117 |
| Pigment 26 | 30 % Gd | erfindungsgemäß | 120 |
| Pigment 27 | 40 % Ho | erfindungsgemäß | 121 |
| Pigment 28 | 40 % Sm | erfindungsgemäß | 123 |
| Pigment 29 | 40 % Tb | erfindungsgemäß | 121 |
| Pigment 30 | 40 % Yb | erfindungsgemäß | 122 |
| Pigment 31 | 40 % Er | erfindungsgemäß | 124 |
| Pigment 32 | 40 % Dy | erfindungsgemäß | 123 |
| Pigment 33 | 40 % Nd | erfindungsgemäß | 124 |
| Pigment 34 | 40 % Eu | erfindungsgemäß | 124 |
| Pigment 35 | 40 % Pr | erfindungsgemäß | 125 |
| Pigment 36 | 40 % La | erfindungsgemäß | 123 |
| Pigment 37 | 40 % Ce | erfindungsgemäß | 124 |
| Pigment 38 | 2,5 % Gd, 2,5 % Ho | | 107 |
| Pigment 39 | 4% Gd, 4 % Ho, 4 % Sm | | 112 |
| Pigment 40 | 2 % Dy, 2 % Ho, 2 % Sm | | 108 |
| Pigment 41 | 10 % Tb, 10 % Yb | | 118 |
| Pigment 42 | 5 % Er, 5 % Dy, 5 % Nd | | 113 |
| Pigment 43 | 2,5 % Pr, 2,5 % Eu | | 109 |
| Pigment 44 | 10 % Pr, 10 % La | | 116 |
| Pigment 45 | 2% La, 2 % Ce, 2% Yb | | 110 |
| Pigment 46 | 5% La, 5% Dy, 5 % Pr, 5 % Ho | | 116 |
| Pigment 47 | 1,5 % Sm, 1,5 % Ho, 1,5 % Eu, 1,5 % Pr | | 108 |
| Pigment 48 | 60 % Gd | nicht erfindungsgemäß | 98 |
| Pigment 49 | 60 % Ho | nicht erfindungsgemäß | 99 |
| Pigment 50 | 60 % Sm | nicht erfindungsgemäß | 97 |
| Pigment 51 | 60 % Tb | nicht erfindungsgemäß | 96 |
| Pigment 52 | 60 % Yb | nicht erfindungsgemäß | 98 |
| Pigment 53 | 60 % Er | nicht erfindungsgemäß | 99 |
| Pigment 54 | 60 % Dy | nicht erfindungsgemäß | 96 |
| Pigment 55 | 60 % Nd | nicht erfindungsgemäß | 98 |
| Pigment 56 | 60 % Eu | nicht erfindungsgemäß | 99 |
| Pigment 57 | 60 % Pr | nicht erfindungsgemäß | 97 |
| Pigment 58 | 60 % La | nicht erfindungsgemäß | 96 |
| Pigment 59 | 60 % Ce | nicht erfindungsgemäß | 98 |
| Pigment 60 | 3 % Gd | nicht erfindungsgemäß | 98 |
| Pigment 61 | 3 % Ho | nicht erfindungsgemäß | 99 |
| Pigment 62 | 3 % Sm | nicht erfindungsgemäß | 96 |
| Pigment 63 | 3 % Tb | nicht erfindungsgemäß | 97 |
| Pigment 64 | 3 % Yb | nicht erfindungsgemäß | 96 |
| Pigment 65 | 3 % Er | nicht erfindungsgemäß | 99 |
| Pigment 66 | 1 % Dy | nicht erfindungsgemäß | 91 |
| Pigment 67 | 1 % Nd | nicht erfindungsgemäß | 95 |
| Pigment 68 | 1 % Eu | nicht erfindungsgemäß | 93 |
| Pigment 69 | 1 % Pr | nicht erfindungsgemäß | 92 |
| Pigment 70 | 1 % La | nicht erfindungsgemäß | 94 |
| Pigment 71 | 1 % Ce | nicht erfindungsgemäß | 95 |

Fazit: Aus Tabelle 1 ist ersichtlich, dass alle erfindungsgemäßen Pigmente erhöhte Farbstärken aufweisen im Vergleich zu den Pigmenten 48 bis 71. Dies bedeutet, dass die erfindungsgemäßen Pigmente bezogen auf gleiche Einwaagen höhere optischen Dichten erreichen als die Pigmente 48 bis 71.

## Patentansprüche

1. Metallazopigmente, **dadurch gekennzeichnet, dass** sie enthalten die Komponenten
a) mindestens zwei Metallazoverbindungen die sich mindestens in der Art des Metalls voneinander unterscheiden, und die jeweils
• Struktureinheiten der Formel (I), oder deren tautomeren Formen, 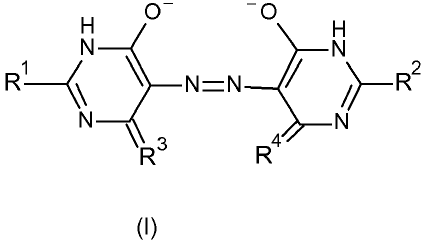 worin
R¹ und R² unabhängig voneinander für OH, NH₂ oder NHR⁵ stehen,
R³ und R⁴ unabhängig voneinander für =O oder =NR⁵ stehen,
R⁵ für Wasserstoff oder Alkyl, vorzugsweise C₁-C₄-Alkyl, steht,
und
• Ni²⁺-Metallionen beziehungsweise ein oder mehrere Metallionen Me¹ und gegebenenfalls ein oder mehrere Metallionen Me² enthalten,
wobei
Me¹ für ein Metallion ausgewählt aus der Reihe La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺, Yb²⁺ und Yb³⁺ steht,
und
Me² für ein Metallion ausgewählt aus der Reihe
Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Fe²⁺, Fe³⁺, Co²⁺, Co³⁺, Cu²⁺, Zn²⁺, Cd²⁺, Al³⁺ und Pb²⁺ steht,
mit der Maßgabe, dass die Menge an Ni²⁺-Metallionen und Metallionen aus der Reihe Me¹ zusammen 95 bis 100 Mol-% beträgt und die Menge an Metallionen aus der Reihe Me² 0 bis 5 Mol-% beträgt, jeweils bezogen auf ein Mol aller Metallionen im Metallazopigment,
und
wobei das Molverhältnis von Ni²⁺- Metallionen zu Me¹ Metallionen im Metallazopigment 2 : 1 bis 4 : 1 und bevorzugt 2,3 : 1 bis 3 : 1 beträgt,
und
b) mindestens eine Verbindung der Formel (II) 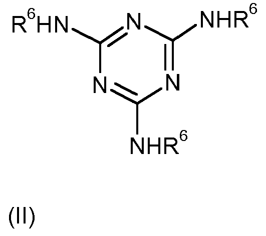 worin
R⁶ für Wasserstoff oder Alkyl, vorzugsweise C₁-C₄-Alkyl das gegebenenfalls ein- oder mehrfach durch OH substituiert ist,
steht.

2. Metallazopigmente gemäß Anspruch 1, **dadurch gekennzeichnet, dass** die Komponenten a) und die Komponenten b) gemeinsam in Form von Addukten vorliegen.

3. Metallazopigmente gemäß Anspruch 1 oder 2, **dadurch gekennzeichnet, dass** in Formel (I)
R¹ und R² für OH stehen,
und
R³ und R⁴ für =O stehen,
und in Formel (II)
R⁶ für Wasserstoff steht.

4. Metallazopigmente gemäß wenigstens einem der Ansprüche 1 bis 3, **dadurch gekennzeichnet, dass** die Menge an Ni²⁺-Ionen und Metallionen aus der Reihe Me¹ 100 Mol-% beträgt, bezogen auf ein Mol aller Metallionen.

5. Metallazopigmente gemäß wenigstens einem der Ansprüche 1 bis 4, **dadurch gekennzeichnet**, das Molverhältnis von Ni²⁺- Metallionen zu Me¹ Metallionen 2,3 : 1 bis 3 : 1 beträgt,

6. Metallazopigmente gemäß wenigstens einem der Ansprüche 1 bis 5, **dadurch gekennzeichnet, dass** pro Mol an Struktureinheiten der Formel (I) 0,05 bis 4 Mol, bevorzugt 0,5 bis 2,5 Mol und ganz besonders bevorzugt 1,0 bis 2,0 Mol an Verbindung der Formel (II) enthalten ist.

7. Metallazopigmente gemäß wenigstens einem der Ansprüche 1 bis 6, **dadurch gekennzeichnet, dass** sie eine spezifische Oberfläche von 20 bis 200 m²/g, bevorzugt von 60 bis 160 m²/g und ganz besonders bevorzugt von 90 bis 150 m²/g besitzen.

8. Verfahren zur Herstellung von Metallazopigmenten gemäß wenigstens einem der Ansprüche 1 bis 7, **dadurch gekennzeichnet dass** eine Verbindung der Formel (III), oder deren Tautomere, 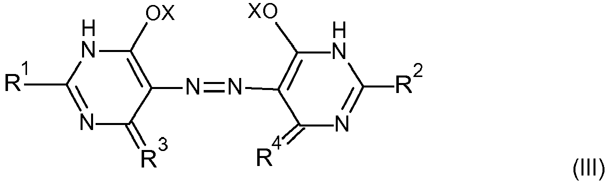 worin
X für ein Alkalimetallion, vorzugsweise für ein Natrium- oder Kaliumion steht,
R¹ und R² unabhängig voneinander für OH, NH₂ oder NHR⁵ stehen,
R³ und R⁴ unabhängig voneinander für =O oder =NR⁵ stehen,
und
R⁵ für Wasserstoff oder Alkyl, vorzugsweise C₁-C₄-Alkyl, steht,
in Gegenwart von mindestens einer Verbindung der Formel (II) 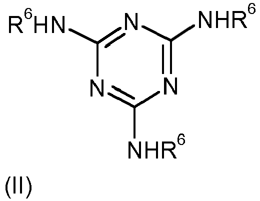 worin
R⁶ für Wasserstoff oder Alkyl, vorzugsweise C₁-C₄-Alkyl das gegebenenfalls ein- oder mehrfach durch OH substituiert ist, steht,
gleichzeitig oder nacheinander mit mindestens einem Nickelsalz und mindestens einem weiteren Metallsalz aus der Reihe der zwei- oder dreiwertigen La³⁺-, Ce³⁺-, Pr³⁺-, Nd²⁺-, Nd³⁺-, Sm²⁺-, Sm³⁺-, Eu²⁺-, Eu³⁺-, Gd³⁺-, Tb³⁺-, Dy³⁺-, Ho³⁺-, Er³⁺-, Tm³⁺-, Yb²⁺ - und Yb³⁺ -Salze, bevorzugt aus der Reihe der La³⁺-, Ce³⁺-, Pr³⁺-, Nd³⁺-, Sm³⁺-, Eu³⁺-, Gd³⁺-, Tb³⁺-, Dy³⁺-, Ho³⁺-, Er³⁺-, Tm³⁺- und Yb³⁺-Salze und besonders bevorzugt aus der Reihe der La³⁺-, Ce³⁺-, Pr³⁺-, Nd³⁺-, Sm³⁺-, Tb³⁺- und Ho³⁺-Salze und gegebenenfalls mit einem oder mehreren Metallsalzen aus der Reihe der Mg²⁺-, Ca²⁺-, Sr²⁺-, Ba²⁺-, Sc³⁺-, Y³⁺-, Ti²⁺-, Ti³⁺-, Zr²⁺-, Zr³⁺, V²⁺-, V³⁺-, Nb³⁺-, Cr³⁺-, Mo²⁺-, Mo³⁺-, Mn²⁺-, Fe²⁺-, Fe³⁺-, Co²⁺-, Co³⁺-, Cu²⁺-, Zn²⁺-, Cd²⁺-, Al³⁺ - und Pb²⁺-Salze, bevorzugt aus der Reihe der Mg²⁺-, Ca²⁺-, Sr²⁺-, Y³⁺-, Mn²⁺-, Fe²⁺-, Fe³⁺-, Co²⁺-, Co³⁺-, Cu²⁺-, Zn²⁺-, Al³⁺- Salze und besonders bevorzugt aus der Reihe der Sr²⁺-, Fe²⁺-, Fe³⁺-, Co²⁺-, Co³⁺-, Cu²⁺-, Zn²⁺- und Al³⁺-Salze umsetzt, wobei pro Mol an Verbindung der Formel (III) 0,66 bis 0,8 Mol mindestens eines Nickelsalz, 0,2 bis 0,33 Mol mindestens eines Me¹- Salzes und höchstens 0,05 Mol mindestens eines Me²- Salzes eingesetzt werden, und wobei die Summe der Molmengen der insgesamt eingestzten Metallsalze ein Mol beträgt.

9. Pigmentpräparationen enthaltend wenigstens ein Metallazopigment gemäß wenigstens einem der Ansprüche 1 bis 7 und wenigstens einen Hilfs- und/oder Zusatzstoff, vorzugsweise aus der Reihe der oberflächenaktiven Mittel, der Oberflächenbelegungsmittel, der Basen und der Lösungsmittel, und gegebenenfalls wenigstens ein weiteres Pigment.

10. Pigmentpräparation gemäß Anspruch 9, **dadurch gekennzeichnet, dass** sie als weiteres Pigment C.I. Pigment Green 36 und/oder C.I. Pigment Green 58 enthält.

11. Verfahren zur Herstellung einer Pigmentpräparation nach wenigstens einem der Ansprüche 9 bis 10, **dadurch gekennzeichnet, dass** wenigstens ein Metallazopigment gemäß wenigstens einem der Ansprüche 1 bis 7 mit wenigstens einem Hilfs- und/ oder Zusatzstoff, vorzugsweise aus der Reihe der oberflächenaktiven Mittel, der Oberflächenbelegungsmittel, der Basen und der Lösungsmittel, und gegebenenfalls mit wenigstens einem weiteren Pigment vermischt oder vermahlen wird.

12. Verwendung eines Metallazopigments gemäß wenigstens einem der Ansprüche 1 bis 7 zur Herstellung von Pigmentpräparationen.

13. Verwendung eines Metallazopigments gemäß wenigstens einem der Ansprüche 1 bis 7 oder einer Pigmentpräparation gemäß wenigstens einem der Ansprüche 9 bis 10 zur Einfärbung von Ink Jet Tinten, Farbfiltern für Flüssigkristallanzeigen, Druckfarben, Leimfarben oder Binderfarben, für die Massefärbung von synthetischen, halbsynthetischen oder natürlichen makromolekularen Stoffen, insbesondere Polyvinylchlorid, Polystyrol, Polyamid, Polyethylen oder Polypropylen, sowie für die Spinnfärbung von natürlichen, regenerierten oder künstlichen Fasern, wie z.B. Cellulose-, Polyester-, Polycarbonat-, Polyacrylnitril- oder Polyamidfasern, sowie zum Bedrucken von Textilien und Papier.

14. Farbfilter, Photolack, Drucktinte oder Flüssigkristallanzeige enthaltend wenigstens ein Metallazopigment gemäß wenigstens einem der Ansprüche 1 bis 7 oder eine Pigmentpräparation gemäß wenigstens einem der Ansprüche 9 bis 10.

15. Photolack enthaltend wenigstens ein Metallazopigment gemäß wenigstens einem der Ansprüche 1 bis 7, oder eine Pigmentpräparation gemäß wenigstens einem der Ansprüche 9 bis 10, und ein oder mehrere photohärtbare Monomere und ein oder mehrere Photoreaktionsstarter und gegebenenfalls ein oder mehrere Binde- oder Dispergiermittel und/oder Lösungsmittel.

16. Verfahren zur Herstellung von Farbfiltern für Flüssigkristallanzeigen umfassend die Schritte a) Auftragen eines Photolacks gemäß Anspruch 15 auf ein Substrat, b) Belichtung mittels Photomaske, c) Härtung und d) Entwicklung zum fertigen farbigen Farbfilter.

## Claims

1. Metal azo pigments, **characterized in that** they comprise the following components:
a) at least two metal azo compounds which differ at least in the type of metal and which each contain
• structural units of the formula (I), or the tautomeric forms thereof, 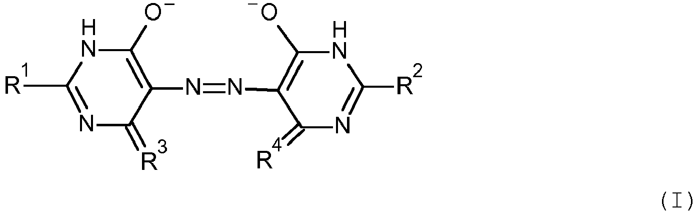 in which
R¹ and R² are each independently OH, NH₂ or NHR⁵,
R³ and R⁴ are each independently =O or =NR⁵,
R⁵ is hydrogen or alkyl, preferably C₁-C₄-alkyl,
and
• Ni²⁺ metal ions and/or one or more metal ions Me¹ and optionally one or more metal ions Me², where Me¹ is a metal ion selected from the group of La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺, Yb²⁺ and Yb³⁺,
and
Me² is a metal ion selected from the group of Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Fe²⁺, Fe³⁺, Co²⁺, Co³⁺, Cu²⁺, Zn²⁺, Cd²⁺, Al³⁺ and Pb²⁺,
with the proviso that the amount of Ni²⁺ metal ions and metal ions from the Me¹ group together is 95 to 100 mol% and the amount of metal ions from the Me² group is 0 to 5 mol%, based in each case on one mole of all metal ions in the metal azo pigment,
and
where the molar ratio of Ni²⁺ metal ions to Me¹ metal ions in the metal azo pigment is 2:1 to 4:1 and preferably 2.3:1 to 3:1,
and
b) at least one compound of the formula (II) 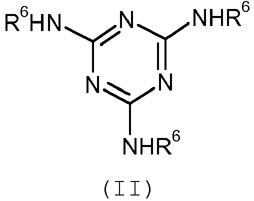 in which
R⁶ is hydrogen or alkyl, preferably C₁-C₄-alkyl optionally mono- or polysubstituted by OH.

2. Metal azo pigments according to Claim 1, **characterized in that** components a) and components b) are present together in the form of adducts.

3. Metal azo pigments according to Claim 1 or 2, **characterized in that**, in formula (I),
R¹ and R² are OH,
and
R³ and R⁴ are =O,
and, in formula (II),
R⁶ is hydrogen.

4. Metal azo pigments according to at least one of Claims 1 to 3, **characterized in that** the amount of Ni²⁺ ions and metal ions from the Me¹ group is 100 mol%, based on one mole of all metal ions.

5. Metal azo pigments according to at least one of Claims 1 to 4, **characterized in that** the molar ratio of Ni²⁺ metal ions to Me¹ metal ions is 2.3:1 to 3:1.

6. Metal azo pigments according to at least one of Claims 1 to 5, **characterized in that** 0.05 to 4 mol, preferably 0.5 to 2.5 mol and most preferably 1.0 to 2.0 mol of compounds of the formula (II) is present per mole of structural units of the formula (I).

7. Metal azo pigments according to at least one of Claims 1 to 6, **characterized in that** they have a specific surface area of 20 to 200 m²/g, preferably of 60 to 160 m²/g and most preferably of 90 to 150 m²/g.

8. Process for producing metal azo pigments according to at least one of Claims 1 to 7, **characterized in that** a compound of the formula (III), or tautomers thereof, 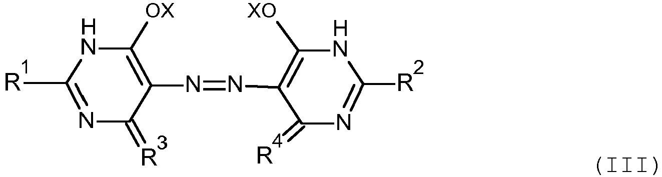 in which
X is an alkali metal ion, preferably a sodium or potassium ion,
R¹ and R² are each independently OH, NH₂ or NHR⁵,
R³ and R⁴ are each independently =O or =NR⁵,
and
R⁵ is hydrogen or alkyl, preferably C₁-C₄-alkyl,
in the presence of at least one compound of the formula (II) 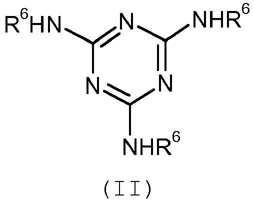 in which
R⁶ is hydrogen or alkyl, preferably C₁-C₄-alkyl optionally mono- or polysubstituted by OH,
is reacted simultaneously or successively with at least one nickel salt and at least one further metal salt from the group of the di- or trivalent La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺, Yb²⁺ and Yb³⁺ salts, preferably from the group of the La³⁺, Ce³⁺, Pr³⁺, Nd³⁺, Sm³⁺, Eu³⁺, Gd³⁺, Tb³⁺, Dy³⁺, Ho³⁺, Er³⁺, Tm³⁺and Yb³⁺ salts and more preferably from the group of the La³⁺, Ce³⁺, Pr³⁺, Nd³⁺, Sm³⁺, Tb³⁺and Ho³⁺ salts and optionally with one or more metal salts from the group of the Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Fe²⁺, Fe³⁺, Co²⁺, Co³⁺, Cu²⁺, Zn²⁺, Cd²⁺, Al³⁺ and Pb²⁺ salts, preferably from the group of the Mg²⁺, Ca²⁺, Sr²⁺, Y³⁺, Mn²⁺, Fe²⁺, Fe³⁺, Co²⁺, Co³⁺, Cu²⁺, Zn², Al³⁺ salts and more preferably from the group of the Sr²⁺, Fe²⁺, Fe³⁺, Co²⁺, Co³⁺, Cu²⁺, Zn²⁺ and Al³⁺ salts, where 0.66 to 0.8 mol of at least one nickel salt, 0.2 to 0.33 mol of at least one Me¹ salt and at most 0.05 mol of at least one Me² salt are used per mole of compound of the formula (III), and where the sum total of the molar amounts of the metal salts used together is one mole.

9. Pigment preparations comprising at least one metal azo pigment according to at least one of Claims 1 to 7 and at least one auxiliary and/or additive, preferably from the group of the surface-active agents, the surface-covering agents, the bases and the solvents, and optionally at least one further pigment.

10. Pigment preparation according to Claim 9, **characterized in that** it comprises C.I. Pigment Green 36 and/or C.I. Pigment Green 58 as a further pigment.

11. Process for producing a pigment preparation according to at least one of Claims 9 and 10, **characterized in that** at least one metal azo pigment according to at least one of Claims 1 to 7 is mixed or ground with at least one auxiliary and/or additive, preferably from the group of the surface-active agents, the surface-covering agents, the bases and the solvents, and optionally with at least one further pigment.

12. Use of a metal azo pigment according to at least one of Claims 1 to 7 for production of pigment preparations.

13. Use of a metal azo pigment according to at least one of Claims 1 to 7 or of a pigment preparation according to at least one of Claims 9 and 10 for colouring inkjet inks, colour filters for liquid-crystal displays, printing inks, distempers or emulsion paints, for the bulk colouring of synthetic, semisynthetic or natural macromolecular substances, especially polyvinyl chloride, polystyrene, polyamide, polyethylene or polypropylene, and for the spin dyeing of natural, regenerated or synthetic fibres, for example cellulose, polyester, polycarbonate, polyacrylonitrile or polyamide fibres, and for printing of textiles and paper.

14. Colour filter, photoresist, printing ink or liquid-crystal display comprising at least one metal azo pigment according to at least one of Claims 1 to 7 or a pigment preparation according to at least one of Claims 9 and 10.

15. Photoresist comprising at least one metal azo pigment according to at least one of Claims 1 to 7, or a pigment preparation according to at least one of Claims 9 and 10, and one or more photocurable monomers and one or more reaction photoinitiators and optionally one or more binders or dispersants and/or solvents.

16. Process for producing colour filters for liquid-crystal displays, comprising the steps of a) application of a photoresist according to Claim 15 to a substrate, b) exposure by means of a photomask, c) curing and d) development to give the finished coloured colour filter.

## Revendications

1. Pigments azoïques métalliques, **caractérisés en ce qu'**ils contiennent les composants suivants :
a) au moins deux composés azoïques métalliques qui diffèrent l'un de l'autre au moins au niveau du type de métal, et qui contiennent chacun
- des unités structurales de formule (I), ou leurs formes tautomères 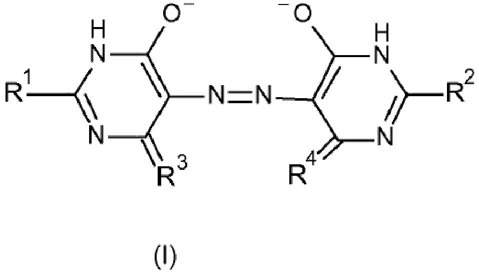 dans laquelle
R¹ et R² représentent indépendamment l'un de l'autre OH, NH₂ ou NHR⁵,
R³ et R⁴ représentent indépendamment l'un de l'autre =O ou =NR⁵,
R⁵ représente hydrogène ou alkyle, de préférence alkyle en C₁-C₄,
et
- des ions métalliques Ni²⁺ ou un ou plusieurs ions métalliques Me¹ et éventuellement un ou plusieurs ions métalliques Me²,
Me¹ représentant un ion métallique choisi dans la série constituée par La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺, Yb²⁺ et Yb³⁺ ,
et
Me² représentant un ion métallique choisi dans la série constituée par Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Fe²⁺, Fe³⁺, Co²⁺, Co³⁺, Cu²⁺, Zn²⁺, Cd²⁺, Al³⁺ et Pb²⁺,
à condition que la quantité d'ions métalliques Ni²⁺ et d'ions métalliques de la série Me¹ soit au total de 95 à 100 % en moles et que la quantité d'ions métalliques de la série Me² soit de 0 à 5 % en moles, à chaque fois par rapport à une mole de tous les ions métalliques dans le pigment azoïque métallique,
et
le rapport molaire entre les ions métalliques Ni²⁺ et les ions métalliques Me¹ dans le pigment azoïque métallique étant de 2:1 à 4:1 et de préférence de 2,3:1 à 3:1,
et
b) au moins un composé de formule (II) 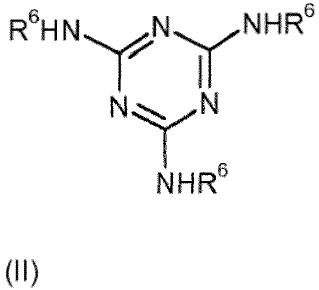 dans laquelle
R⁶ représente hydrogène ou alkyle, de préférence alkyle en C₁-C₄ qui est éventuellement substitué une ou plusieurs fois par OH.

2. Pigments azoïques métalliques selon la revendication 1, **caractérisés en ce que** les composants a) et les composants b) sont présents ensemble sous la forme d'adduits.

3. Pigments azoïques métalliques selon la revendication 1 ou 2, **caractérisés en ce que**, dans la formule (I),
R¹ et R² représentent OH,
et
R³ et R⁴ représentent =O,
et, dans la formule (II),
R⁶ représente hydrogène.

4. Pigments azoïques métalliques selon au moins l'une quelconque des revendications 1 à 3, **caractérisés en ce que** la quantité d'ions Ni²⁺ et d'ions métalliques de la série Me¹ est de 100 % en moles, par rapport à une mole de tous les ions métalliques.

5. Pigments azoïques métalliques selon au moins l'une quelconque des revendications 1 à 4, **caractérisés en ce que** le rapport molaire entre les ions métalliques Ni²⁺ et les ions métalliques Me¹ est de 2,3:1 à 3:1.

6. Pigments azoïques métalliques selon au moins l'une quelconque des revendications 1 à 5, **caractérisés en ce que**, par mole d'unités structurales de formule (I), 0,05 à 4 moles, de préférence 0,5 à 2,5 moles et de manière tout particulièrement préférée 1,0 à 2,0 moles, de composé de formule (II) est contenu.

7. Pigments azoïques métalliques selon au moins l'une quelconque des revendications 1 à 6, **caractérisés en ce qu'**ils présentent une surface spécifique de 20 à 200 m²/g, de préférence de 60 à 160 m²/g et de manière tout particulièrement préférée de 90 à 150 m²/g.

8. Procédé de fabrication de pigments azoïques métalliques selon au moins l'une quelconque des revendications 1 à 7, **caractérisé en ce qu'**un composé de formule (III) ou ses tautomères 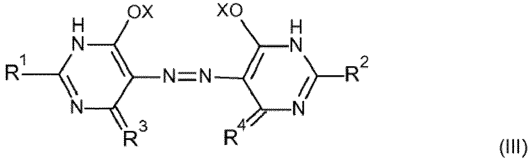 dans laquelle
X représente un ion de métal alcalin, de préférence un ion sodium ou potassium,
R¹ et R² représentent indépendamment l'un de l'autre OH, NH₂ ou NHR⁵,
R³ et R⁴ représentent indépendamment l'un de l'autre =O ou =NR⁵,
et
R⁵ représente hydrogène ou alkyle, de préférence alkyle en C₁-C₄,
est mis en réaction en présence d'au moins un composé de formule (II) 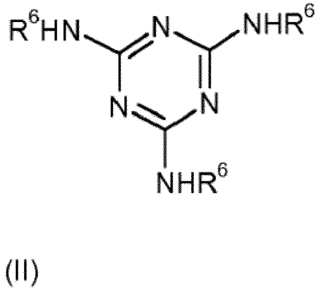 dans laquelle
R⁶ représente hydrogène ou alkyle, de préférence alkyle en C₁-C₄ qui est éventuellement substitué une ou plusieurs fois par OH,
simultanément ou successivement avec au moins un sel de nickel et au moins un autre sel métallique de la série constituée par les sels bi- ou trivalents La³⁺, Ce³⁺, Pr³⁺, Nd²⁺, Nd³⁺, Sm²⁺, Sm³⁺, Eu²⁺, Eu³⁺, Gd³⁺, Tb³⁺, Dy³⁺, Ho³⁺, Er³⁺, Tm³⁺, Yb²⁺ et Yb³⁺, de préférence de la série constituée par La³⁺, Ce³⁺, Pr³⁺, Nd³⁺, Sm³⁺, Eu³⁺, Gd³⁺, Tb³⁺, Dy³⁺, Ho³⁺, Er³⁺, Tm³⁺, et Yb³⁺, et de manière particulièrement préférée de la série constituée par La³⁺, Ce³⁺, Pr³⁺, Nd³⁺, Sm³⁺, Tb³⁺ et Ho³⁺, et éventuellement avec un ou plusieurs sels métalliques de la série constituée par Mg²⁺, Ca²⁺, Sr²⁺, Ba²⁺, Sc³⁺, Y³⁺, Ti²⁺, Ti³⁺, Zr²⁺, Zr³⁺, V²⁺, V³⁺, Nb³⁺, Cr³⁺, Mo²⁺, Mo³⁺, Mn²⁺, Fe²⁺, Fe³⁺, Co²⁺, Co³⁺, Cu²⁺, Zn²⁺, Cd²⁺, Al³⁺ et Pb²⁺, de préférence de la série constituée par Mg²⁺, Ca²⁺, Sr²⁺, Y³⁺, Mn²⁺, Fe²⁺, Fe³⁺, Co²⁺, Co³⁺, Cu²⁺, Zn²⁺, Al³⁺, et de manière particulièrement préférée de la série constituée par Sr²⁺, Fe²⁺, Fe³⁺, Co²⁺, Co³⁺, Cu²⁺, Zn²⁺ et Al³⁺, par mole de composé de formule (III), 0,66 à 0,8 mole d'au moins un sel de nickel, 0,2 à 0,33 mole d'au moins un sel Me¹ et au plus 0,05 mole d'au moins un sel Me² étant utilisés, et la somme des quantités molaires des sels métalliques utilisés au total étant d'une mole.

9. Préparations pigmentaires contenant au moins un pigment azoïque métallique selon au moins l'une quelconque des revendications 1 à 7 et au moins un adjuvant et/ou additif, de préférence de la série constituée par les agents tensioactifs, les agents de recouvrement de surface, les bases et les solvants, et éventuellement au moins un autre pigment.

10. Préparation pigmentaire selon la revendication 9, **caractérisée en ce qu'**elle contient en tant qu'autre pigment C.I. Pigment Green 36 et/ou C.I. Pigment Green 58.

11. Procédé de fabrication d'une préparation pigmentaire selon au moins l'une quelconque des revendications 9 à 10, **caractérisé en ce qu'**au moins un pigment azoïque métallique selon au moins l'une quelconque des revendications 1 à 7 est mélangé ou broyé avec au moins un adjuvant et/ou additif, de préférence de la série constituée par les agents tensioactifs, les agents de recouvrement de surface, les bases et les solvants, et éventuellement avec au moins un autre pigment.

12. Utilisation d'un pigment azoïque métallique selon au moins l'une quelconque des revendications 1 à 7 pour la fabrication de préparations pigmentaires.

13. Utilisation d'un pigment azoïque métallique selon au moins l'une quelconque des revendications 1 à 7 ou d'une préparation pigmentaire selon au moins l'une quelconque des revendications 9 à 10 pour la coloration d'encres jet d'encre, de filtres colorés pour écrans à cristaux liquides, d'encres d'impression, de peintures à la colle ou de peintures-émulsions, pour la coloration en masse de matières macromoléculaires synthétiques, semi-synthétiques ou naturelles, notamment de polychlorure de vinyle, de polystyrène, de polyamide, de polyéthylène ou de polypropylène, ainsi que pour la coloration par filage de fibres naturelles, régénérées ou synthétiques, telles que p. ex. des fibres de cellulose, de polyester, de polycarbonate, de polyacrylonitrile ou de polyamide, ainsi que pour l'impression de textiles et de papier.

14. Fibre coloré, vernis photorésistant, encre d'impression ou écran à cristaux liquides contenant au moins un pigment azoïque métallique selon au moins l'une quelconque des revendications 1 à 7 ou une préparation pigmentaire selon au moins l'une quelconque des revendications 9 à 10.

15. Vernis photorésistant contenant au moins un pigment azoïque métallique selon au moins l'une quelconque des revendications 1 à 7 ou une préparation pigmentaire selon au moins l'une quelconque des revendications 9 à 10, et un ou plusieurs monomères photodurcissables et un ou plusieurs démarreurs de photoréaction et éventuellement un ou plusieurs liants ou dispersants et/ou solvants.

16. Procédé de fabrication de filtres colorés pour écrans à cristaux liquides comprenant les étapes suivantes : a) l'application d'un vernis photorésistant selon la revendication 15 sur un substrat, b) l'illumination au moyen d'un masque photorésistant, c) le durcissement et d) le développement pour former le filtre coloré fini.
